# EUROPÄISCHE PATENTSCHRIFT

(11) **EP 4 297 914 B1**
(45) Veröffentlichungstag und Bekanntmachung des Hinweises auf die Patenterteilung: **09.09.2026**
(21) Anmeldenummer: 22710300.9
(22) Anmeldetag: 10.02.2022
(51) Int. Cl.: B06B 1/06, G01S 7/521, G01S 15/10, G01S 15/931

(54) **ULTRASCHALLWANDLER**
ULTRASONIC TRANSDUCER
TRANSDUCTEUR À ULTRASONS

(30) Priorität: 26.02.2021 DE 102021104697
(43) Veröffentlichungstag der Anmeldung: 03.01.2024
(60) Teilanmeldung: 26183243.0 / 4 782 883
(73) Patentinhaber: TDK Electronics AG, 81671 München (DE)
(72) Erfinder: GEBHART, Michael, 4020 Linz (AT); SAX, Stefan, 8054 Graz (AT); HEDHILI, Amira, 8020 Graz (AT); LUCCHI, Martina, 8053 Graz (AT); LUKAN, Peter, 8530 Deutschlandsberg (AT); KREITER, Johann, 8530 Deutschlandsberg (AT); PICHLER, Johann, 8614 Breitenau am Hochlantsch (AT); BAUMANN, Pierre, 8042 Graz (AT); MOHRMANN, Jens, 8010 Graz (AT); KÜGERL, Georg, 8552 Eibiswald (AT)
(74) Vertreter: Epping - Hermann - Fischer
(86) Internationale Anmeldenummer: PCT/EP2022/053221
(87) Internationale Veröffentlichungsnummer: WO 2022/179857

(56) Entgegenhaltungen:
- WO-A2-2020/245064
- DE-A1- 102005 012 041
- DE-A1- 102008 027 687
- DE-A1- 102013 213 476
- DE-A1- 102015 202 393
- DE-A1- 102018 213 293
- DE-A1- 19 620 826
- DE-B3- 102018 201 404
- JP-A- 2006 246 251
- US-A- 5 383 465

## Beschreibung

Die Erfindung betrifft einen Ultraschallwandler und ein Verfahren zur Herstellung eines Ultraschallwandlers.

Ultraschallwandler werden im Allgemeinen zur Distanzmessung benutzt. Im Sendebetrieb wird bei der Distanzmessung ein Ultraschallsignal als Burst vom Ultraschallwandler ausgesandt, das, nachdem es auf ein Objekt trifft, teilweise wieder zurück reflektiert wird. Im Empfangsbetrieb wird dieser zurückreflektierte Puls detektiert, wodurch eine Laufzeit ermittelt werden kann. Da die Ultraschallwellen sich in Luft aber auch in Wasser mit bekannten Schallgeschwindigkeiten ausbreiten, kann mit Hilfe der Laufzeit die Distanz zu dem reflektierten Objekt berechnet werden.

Autos setzten die Distanzmessung mittels Ultraschall beispielsweise bei Einpark-Assistenzsystemen ein, die dem Fahrer bei einem geringen Abstand zu einem nahen Objekt ein Warnsignal mitteilen. Die Ultraschallwandler sind meist in den Stoßstangen untergebracht, die relativ viel Raum für den Einbau eines Ultraschallwandlers samt einem Gehäuse und der benötigten Elektronik bieten.

Die Druckschrift WO 2020/245064 A2 beschreibt einen Ultraschallwandler, in dem ein Piezoelement und eine Auswerteelektronik mittels Drähten verbunden sind.

Die Druckschrift WO 2016/184604 A1 beschreibt einen Ultraschallwandler mit einem Piezoelement, dessen Elektroden jeweils entgegengesetzte Oberflächen und Seitenflächen des Piezoelements bedecken.

Die Druckschrift EP 2133156 B1 beschreibt einen Ultraschallwandler mit einem Piezoelement, in dem das Piezoelement an einer Seite, die keine Elektroden aufweist, im Ultraschallwandler verklebt ist.

Weitere Ausführungsformen gemäß dem Stand der Technik sind in den Druckschriften DE 10 2005 012 041 A1, DE 19 620 826 A1, US 5 383 465 A, DE 10 2015 202 393 A1 und DE 10 2018 213 293 A1 offenbart.

Die Druckschrift DE 10 2018 201 404 B3 offenbart einen Ultraschallwandler mit einer Piezokeramik und einem Gehäuse, welches ein topfförmiges Gehäuseunterteil und einen Deckel aufweist. Die Piezokeramik umfasst zwei Elektroden unterschiedlicher Polarität, die auf verschiedene Seiten der Piezokeramik aufgebracht sind, wobei Kontaktflächen zur elektrischen Kontaktierung beider Elektroden auf derselben Seite der Piezokeramik angeordnet sind.

Aus den Druckschriften JP 2006 246251 A und DE 10 2008 027 687 A1 ist insbesondere ein Ultraschallwandler mit einem Gehäuse bekannt, welches selbst elektrisch leitend ist und als eine Leiterbahn genutzt wird.

Die Druckschrift DE 10 2013 213476 A1 offenbart weiterhin einen Ultraschallwandler mit einem hybriden spritzgegossenen Gehäuse mit integrierten elektrischen Leiterbahnen.

Neue technologische Entwicklungen und Anwendungen wie beispielsweise Drohnen oder autonome Roboter stellen neue Herausforderungen an einen Ultraschallwandler, der zur Distanzmessung geeignet ist.

Ein Ultraschallwandler, der kompakt, robust und kostengünstig in der Herstellung ist, ist daher wünschenswert.

Eine Aufgabe der vorliegenden Erfindung ist es daher, einen verbesserten Ultraschallwandler und ein geeignetes Herstellungsverfahren bereitzustellen.

Diese Aufgabe wird zumindest teilweise durch einen Ultraschallwandler gemäß dem unabhängigen Anspruch 1, durch einen Ultraschallwandler gemäß dem unabhängigen Anspruch 2 sowie durch ein Verfahren gemäß dem unabhängigen Anspruch 15 gelöst.

Der Umfang der Erfindung ist durch die Ansprüche definiert. Beispiele und Ausführungsformen, die nicht in den Bereich der Ansprüche fallen, sind nicht Teil des gegenwärtigen Erfindungsumfanges.

Es wird ein Ultraschallwandler beschrieben, der einen Träger mit Leiterbahnen und ein piezoelektrisches Element mit Elektroden umfasst. Das piezoelektrische Element weist eine Kontaktseite auf, die auf dem Träger befestigt ist. Die Leiterbahnen des Trägers und die Elektroden des piezoelektrischen Elements sind über die Kontaktseite des Elements elektrisch gekoppelt. Das heißt in anderen Worten, dass die Leiterbahnen des Trägers und die Elektroden des piezoelektrischen Elements an der Kontaktseite des Elements elektrisch gekoppelt sind.

Die Kontaktseite ist die Seite des piezoelektrischen Elements, die dem Träger zugewandt ist. Die Kontaktseite kann eine Unterseite des piezoelektrischen Elements sein.

Durch eine elektrische Kopplung zwischen den Elektroden und den Kontakten kann bevorzugt auf weitere Bauteile zur elektrischen Kontaktierung des piezoelektrischen Elements, insbesondere Drähte, verzichtet werden. Insbesondere können Elektroden und Kontakte direkt elektrisch gekoppelt sein. Der Aufbau des Ultraschallwandlers wird somit kompakter und robuster und ein Fertigungsprozess des Ultraschallwandlers wird vereinfacht und kostengünstiger.

Der Träger kann im Ultraschallwandler die Funktion einer Membran erfüllen. Insbesondere ist der Träger der Boden eines Behältnisses des Ultraschallwandlers.

Das piezoelektrische Element kann als Scheibe ausgeführt sein, also als ein geometrischer Körper, dessen Höhe senkrecht zur Kontaktseite deutlich geringer ist als dessen übrige Ausdehnungen. Das piezoelektrische Element kann insbesondere als flacher Zylinder ausgeführt sein. Der Durchmesser des Zylinders ist deutlich größer als die Höhe des Zylinders. In weiteren Ausführungen kann das piezoelektrische Element eine beliebige andere Form, beispielsweise eine andere rotationssymmetrische Form, eine elliptische Form, eine beliebige n-eckige (n = 3, 4, 5, 6, ...) oder eine kubische Form aufweisen.

Das piezoelektrische Element umfasst ein piezoelektrisches Material. Das piezoelektrische Material kann eine piezoelektrische Keramik oder ein piezoelektrisches Polymer umfassen.

In zumindest einer Ausführung sind die Elektroden im Betriebszustand unterschiedlich polarisiert, also z.B. positiv und negativ polarisiert. So kann über die Elektroden eine Spannung an das piezoelektrische Element angelegt werden.

In zumindest einer Ausführung wird zwischen den Elektroden im Betriebszustand eine Spannung angelegt. Die Elektroden sind so am piezoelektrischen Element angeordnet, das über die Elektroden eine Spannung an das Element angelegt wird.

Alle im Folgenden beschriebenen Merkmale können auch den zuvor beschriebenen Ultraschallwandler betreffen.

Weiterhin wird ein Ultraschallwandler beschrieben, der ein Behältnis mit einem Boden, der als Träger für das piezoelektrische Element ausgestaltet ist, aufweist. Weiterhin umfasst der Ultraschallwandler eine Wand und eine Einbauöffnung. Die Einbauöffnung ist mit einem Deckel verschließbar. Im Behältnis oder im Deckel bzw. im Behältnis und im Deckel ist Elektronik integriert. Auf dem Träger ist eine Kontaktseite eines piezoelektrischen Elements befestigt. Der Ultraschallwandler umfasst weiterhin Leiterbahnen, die Elektroden des piezoelektrischen Elements und Anschlussstellen der Elektronik elektrisch miteinander verbinden.

Die Elektronik kann insbesondere in der Wand und im Deckel oder ausschließlich im Deckel integriert sein.

Der beschriebene Ultraschallwandler kann alle Merkmale des zuvor beschriebenen Ultraschallwandlers aufweisen.

Insbesondere sind in zumindest einer Ausführung die Elektroden im Betriebszustand unterschiedlich polarisiert, also z.B. positiv und negativ polarisiert. So kann über die Elektroden eine Spannung an das piezoelektrische Element angelegt werden.

In zumindest einer Ausführung wird zwischen den Elektroden im Betriebszustand eine Spannung angelegt. Die Elektroden sind so am piezoelektrischen Element angeordnet, das über die Elektroden eine Spannung an das Element angelegt wird.

Im Sendebetrieb kann das piezoelektrische Element, über eine von der Elektronik angelegte Wechselspannung, zu einer impulsartigen Schwingung, insbesondere einer burstartigen Schwingung, mit einer Frequenz von beispielsweise etwa 30 kHz bis 100 kHz und einer vorbestimmten Anzahl von Perioden angeregt werden. Da das piezoelektrische Element am Träger befestigt ist, kann der Träger als Membran mitschwingen und kann einen Ultraschallkegel aussenden. Trifft der Ultraschallkegel auf ein Objekt oder ein anderes Hindernis, kann der Ultraschallkegel teilweise zurückreflektiert werden. Dieser reflektierte Ultraschallimpuls kann wiederum auf den Träger bzw. die Membran treffen und kann sowohl im Träger als auch in dem piezoelektrischen Element eine mechanische Auslenkung mit der gleichen Frequenz wie die ausgesandte impulsartige Schwingung induzieren. Die mechanische Auslenkung des piezoelektrischen Materials des Elements kann eine Spannungsänderung an den angelegten Elektroden hervorrufen, die wiederum von der Elektronik ausgelesen werden kann. Aus der ermittelten Laufzeit des Ultraschallimpulses sowie der bekannten Schallgeschwindigkeit kann die Distanz zu dem reflektierenden Objekt berechnet werden.

In einer Ausführungsform kann das Behältnis topfförmig ausgeführt sein, wobei der Träger als eine Membran des Ultraschallwandlers fungiert und den Boden eines Topfes bildet, während die Wand eine Wandung des Topfes bildet, die die mit dem Deckel verschließbare Einbauöffnung umgibt.

Im Behältnis sind zwischen dem piezoelektrischen Element und dem Deckel keine weiteren Bauelemente zur elektrischen Kontaktierung wie beispielsweise Drähte erforderlich. Daher kann ein Hohlraum in dem Behältnis zwischen dem Träger mit dem piezoelektrischen Element und dem Deckel durch ein Dämpfungselement ausgefüllt werden.

Das Dämpfungselement kann den gesamten Hohlraum ausfüllen. Das Dämpfungselement kann, sofern es eine geeignete Form aufweist, schon vor dem Einsetzen in den Hohlraum gehärtet sein.

Das Dämpfungselement kann in erster Linie zur Dämpfung der Ultraschallschwingungen von dem piezoelektrischen Element aus in Richtung des Deckels dienen, kann das Behältnis jedoch auch noch zusätzlich stabilisieren. Die wichtigste Materialeigenschaft für das Dämpfungselement ist die Dämpfungskonstante, die bei typischen Ultraschallfrequenzen zwischen 30 kHz und 100 kHz möglichst groß sein sollte. Geeignete Materialien sind Gummis oder Schaumstoffe. Insbesondere Schaumstoffe aus Kunstoffen, wie etwa Silikon, die Gaseinschlüsse aufweisen sind für das Dämpfungselement geeignet.

Das Behältnis kann einstückig oder mehrstückig ausgeführt sein. Das Behältnis kann beispielsweise aus einem separaten Bodenelement und einem separaten Wandelement zusammengesetzt sein.

Das Behältnis kann im Wesentlichen rotationssymmetrisch oder auch kubisch ausgeführt sein. Im Falle einer rotationssymmetrischen Ausführung kann das Behältnis beispielsweise zylinderförmig, konisch oder kegelstumpfförmig ausgeführt sein. Das Behältnis kann dabei ganz oder teilweise der geometrischen Grundform des piezoelektrischen Elements entsprechen, also beispielsweise rund, elliptisch oder eckig sein. Eine Innenform und/oder eine Außenform des Behältnisses können hierbei der Grundform des piezoelektrischen Elements entsprechen, insbesondere können das Bodenelement und/oder das Wandelement der Grundform des piezoelektrischen Elements entsprechen. Das Behältnis weist im Inneren einen Hohlraum auf.

Die Innenform und die Außenform des Behältnisses können in derselben Ausführungsform unterschiedlich sein. Zum Beispiel ist die Umwandung des Hohlraumes im Inneren des Behältnisses kubisch geformt und das Äußere des Behältnisses ist zylindrisch geformt. Weiterhin kann das Behältnis beispielsweise innen konisch und außen zylindrisch oder innen zylindrisch und außen kubisch geformt sein etc. Weitere Kombinationen der Innen- und Außenform sind beliebig möglich.

Bevorzugt sind Innen- und Außenform jedoch gleich geformt. Beispielsweise ist das Behältnis innen kubisch und außen kubisch oder innen zylindrisch und außen zylindrisch geformt Besonders bevorzugt ist eine Ausführung des Behältnisses, die innen und außen konisch bzw. kegelstumpfförmig ist. Diese Ausführungsform bietet den Vorteil einer einfachen Herstellung des Behältnisses, da das Behältnis wegen der gewählten Formgebung einfach mittels Presswerkzeugen beispielsweise per Spritzguss bei Kunststoff oder per Tiefziehen bei Aluminium gefertigt werden kann.

Wenn die Innenform des Behältnisses konisch oder kegelstumpfförmig ist, ist weiterhin die Verwendung von vorgeformten und/oder vorgehärteten Dämpfungselementen besonders vorteilhaft.

In diesem Fall ist im Gegensatz zu unterschiedlichen auftretenden Füllgraden bei flüssig eingebrachten und nachfolgend härtenden Dämpfungsmaterialien bei geeigneter und angepasster Abmessung des Hohlraums im Behältnis und des Dämpfungselements bereits im Vorhinein festgelegt, sodass immer das gleiche Raumvolumen im Behältnis von Dämpfungselement eingenommen wird.

Weiterhin ist so auch, anders als bei der fertigungsbedingten unterschiedlich tiefen Einbringung zylindrischer oder kubischer vorgeformter Dämpfungselemente in zylindrische oder kubisch geformte Behältnisse, bereits im Vorhinein die Setztiefe des Dämpfungselements festgelegt.

Zusätzlich besteht bei dieser Ausführung auch eine einfache Möglichkeit durch geeignete Abmessung des Dämpfungselements gezielt einen vom Dämpfungselement freien Resonanzraum zwischen dem Boden des Behältnisses mit aufgebrachtem Piezoelektrischem Element und dem, dem Boden gegenüberliegenden, Ende des Dämpfungselements reproduzierbar einzustellen, was sich positiv auf die akustischen Eigenschaften des Ultraschallwandlers auswirkt.

Das Behältnis kann aus einem einheitlichen Material oder aus verschiedenen Materialien gefertigt sein. Das Behältnis kann verschiedene Abschnitte umfassen, die aus verschiedenen Materialien gefertigt sind. Das Behältnis kann in unterschiedlichen Abschnitten unterschiedliche geometrische Formen aufweisen.

Das Behältnis ist erfindungsgemäß aus einem elektrisch leitenden Material wie beispielsweise Aluminium oder aus einer Aluminiumlegierung gefertigt sein. Das Behältnis kann in einem nicht-erfindungsgemäßen Beispiel aus einem elektrisch nichtleitenden Material wie einem elektrisch nichtleitenden Kunststoff, beispielsweise LCP (Liquid Crystal Polymere), gefertigt sein.

Das Behältnis, das aus einem elektrisch leitenden Material wie Aluminium gefertigt ist, ist auf seiner Oberfläche mit einer Isolationsschicht beschichtet. Ist der Behälter aus Aluminium gefertigt, kann als Isolationsschicht eine Aluminiumoxidschicht, beispielsweise eine Eloxal-Schicht, gebildet werden.

Ist das Behältnis aus einem elektrisch nicht-leitenden Material kann das Behältnis in einer nicht-erfindungsgemäßen Ausführungsform mit der Elektronik verschaltete Mittel aufweisen, um trotz des nichtleitenden Behältnismaterials eine ausreichende Abschirmung von eingestrahlten elektromagnetischen Störungen in Form einer Faraday-Abschirmung zu gewährleisten. Beispielsweise können im Behältnis, bevorzugt an der Innenseite des Behältnisses, innere Elektrodenstrukturen oder Metallgeflechte wie Kupfernetze vorhanden sein, die mit der Elektronik passend auf Masse verschaltet sind. Die Metallgeflechte bedecken bevorzugt die gesamte Innenseite des Behältnisses.

Weitere Ausgestaltungsmöglichkeiten zur Faraday-Abschirmung sind das Aufbringen einer metallischen Beschichtung auf der Innen- und/oder Außenseite des Behältnisses (z.B. durch Sputtern, Galvanisieren etc.) oder einer leitfähigen Lackierung.

Zusätzlich kann alternativ oder ergänzend zur Faraday-Abschirmung eine mechanische Schutzlackierung auf der Außenseite des Behältnis aufgebracht sein, um z.B. mechanischen Verschleiß der metallischen Beschichtung im alltäglichen Betrieb des Ultraschallwandlers zu vermindern oder zu unterbinden und damit die Lebensdauer der metallischen Beschichtung und damit des Ultraschallwandlers zu erhöhen bzw. den störungsfreien Betrieb sicher zu stellen. Die mechanische Schutzlackierung bedeckt bevorzugt die gesamte Außenseite des Behältnisses.

Ist eine metallische Beschichtung zur Faraday-Abschirmung nur an der Außenseite des Behältnisses angebracht, kann die notwendige elektrische Kontaktierung der Faraday-Abschirmung zur Elektronik in einer Ausführungsform als Durchkontaktierung, z.B. in Form eines Via, durch die Behältniswand hindurch zu den Leiterbahnen im Inneren des Behältnis erfolgen. So kann der Ultraschallwandler vollkommen geschlossen gehalten werden und keine besonders empfindliche Überkontaktierung über die schmale Oberseitenkante um die Einbauöffnung des Behältnisses ist nötig.

Das piezoelektrische Element ist innerhalb des Behältnisses mit seiner Kontaktseite auf dem Träger angeordnet.

Außerdem weist der Ultraschallwandler den Deckel auf, der das Behältnis verschließt. In den Deckel ist die Elektronik integriert, die dazu ausgestaltet ist, das piezoelektrische Element zu steuern und auszulesen. Die Integration der Elektronik im Deckel macht den Ultraschallwandler äußerst kompakt.

Durch die Integration der Elektronik im Deckel ist es nicht nötig, den Ultraschallwandler in ein externes Gehäuse zu bauen, in dem die Elektronik verbaut ist. Indem die Funktion eines schallgebenden Behältnisses mit der Funktion eines Sensor-Gehäuses vereint wird, kann der vorliegende Ultraschallwandler kompakt ausgeführt werden. Darüber hinaus können so Kosten bei der Produktion eingespart werden, da nicht zusätzliche elektrische und mechanische Schnittstellen benötigt werden und auf den Zusammenbau von Ultraschallwandler und Sensor-Gehäuse verzichtet werden kann.

Alternativ oder ergänzend dazu kann die Elektronik auch ganz oder teilweise im Behältnis, insbesondere in und/oder an der Wand, vorgesehen sein.

In einer Ausführungsform des beschriebenen Ultraschallwandlers sind die Leiterbahnen und die Elektroden über die Kontaktseite des piezoelektrischen Elements elektrisch gekoppelt.

An der Kontaktseite des piezoelektrischen Elements sind in einer Ausführungsform zwei Elektroden aufgebracht, die mit zwei Kontakten am Träger des Behältnisses elektrisch gekoppelt sind. Jeweils eine der beiden Elektroden ist dabei mit einem entsprechend korrespondierenden Kontakt gekoppelt.

In einer Ausführungsform sind die Kontakte am Träger des Behältnisses elektrisch mit den jeweils korrespondierenden elektrischen Leiterbahnen gekoppelt. Die Kontakte am Träger des Behältnisses und die jeweiligen korrespondierenden elektrischen Leiterbahnen können dabei insbesondere jeweils ein unmittelbar zusammenhängendes, einheitliches Element darstellen.

Die Elektroden umfassen elektrisch leitende Materialien wie beispielsweise Kupfer, Silber, Nickel oder Chrom. Die Elektroden können beispielsweise per Sputtern oder per Druck, **z.B.** per Siebdruck, aufgebracht werden. Alternativ können die Elektroden durch das Aufbringen eines leitfähigen Polymers gebildet werden.

In einer Ausführungsform ist der Deckel mittels eines elektrisch leitfähigen Deckel-Klebemittels am Behältnis festlegbar. Mittels desselben, elektrisch leitfähigen Deckel-Klebemittels ist die Elektronik elektrisch mit den Leiterbahnen kontaktierbar.

Die Leiterbahnen umfassen ein elektrisch leitendes Material wie beispielsweise Kupfer, Silber, Nickel oder Chrom. Die Leiterbahnen können beispielsweise per Sputtern oder per Druck, z.B. per Siebdruck, aufgebracht werden. Alternativ können die Leiterbahnen durch das Aufbringen eines leitfähigen Polymers gebildet werden.

In einer bevorzugten Ausführungsform sind die Elektroden auf dem piezoelektrischen Element und die Anschlussstellen der Elektronik ausschließlich durch die Leiterbahnen elektrisch verbunden.

Weitere Bauelemente zur elektrischen Kontaktierung wie beispielsweise Drähte sind nicht vorgesehen. Die Elektronik und das piezoelektrische Element sind also drahtlos elektrisch verbunden.

In zumindest einer Ausführungsform kontaktieren die Elektroden die Leiterbahnen elektrisch.

Hierzu kontaktieren die Elektroden die Kontakte der Leiterbahnen am Träger elektrisch. Die Elektroden und die Kontakte stehen in direktem elektrischen Kontakt zueinander.

Der Vorteil dieser Anordnung ist eine sichere und stabile elektrische Verbindung zwischen den Elektroden und den Kontakten am Träger, bzw. am Boden des Behältnisses.

In zumindest einer Ausführungsform sind die Elektroden und die Kontakte der Leiterbahnen spaltfrei miteinander kontaktiert. Vorteilhaft sind in dieser Ausführung die kompakte Anordnung und eine stabile elektrische Verbindung.

Die Elektroden umfassen eine erste und eine zweite Elektrode.

Die erste Elektrode ist flächig auf der Kontaktseite des piezoelektrischen Elements angeordnet. Die erste Elektrode kann dabei einen Großteil der Kontaktseite bedecken.

Ein wesentlicher Abschnitt der zweiten Elektrode ist auf einer Seite des piezoelektrischen Elements aufgebracht, die der Kontaktseite entgegengesetzt ist. Diese Seite wird im Folgenden die Oberseite des piezoelektrischen Elements genannt. Neben dem Teil auf der Oberseite des piezoelektrischen Elements sind weitere Teile der zweiten Elektrode auf einer Seitenfläche und auf der Kontaktseite des piezoelektrischen Elements angeordnet. Die beschriebenen Elektrodenteile der zweiten Elektrode hängen zusammen, insbesondere stehen sie in unmittelbarem elektrischen Kontakt zueinander oder bilden eine einheitliche elektrische Kontaktfläche.

Die beschriebene Anordnung der zweiten Elektrode ermöglicht eine Kontaktierung der beiden Elektroden von derselben Seite, bevorzugt von der Seite, in welche die Kontaktseite des piezoelektrischen Elements weist.

Die elektrische Kontaktierung des piezoelektrischen Elements erfolgt also an derselben Seite, an welcher das piezoelektrische Element mechanisch an einer Trägerinnenseite befestigt ist. Die Trägerinnenseite ist die Seite des Trägers, die in das Innere des Behältnisses gerichtet ist. Die Trägerinnenseite ist der Kontaktseite des piezoelektrischen Elements zugewandt.

Dies vereinfacht den Aufbau und den Fertigungsprozess des Ultraschallwandlers.

In einer Ausführungsform ist die Kontaktseite des piezoelektrischen Elements mittels eines Träger-Klebemittels an dem Träger befestigt. Das Träger-Klebemittel ist also zwischen der Kontaktseite des piezoelektrischen Elements und dem Träger aufgetragen.

Durch das Träger-Klebemittel kann das piezoelektrische Element einfach und in kompakter Weise auf dem Träger befestigt werden. Das Träger-Klebemittel kann als zusammenhängende Klebeverbindung in Form einer Klebeschicht zwischen dem piezoelektrischen Element und dem Träger aufgetragen sein.

In zumindest einer Ausführungsform ist das Träger-Klebemittel elektrisch nichtleitend bzw. isolierend. Das Träger-Klebemittel zwischen der Kontaktseite des piezoelektrischen Elements und dem Träger, dient dann also ausschließlich der mechanischen Fixierung des piezoelektrischen Elements.

Durch die Auswahl eines nichtleitenden Träger-Klebemittels kann ein Kurzschluss zwischen den verschiedenen Elektroden auf der Kontaktseite des piezoelektrischen Elements vermieden werden. Die Klebeverbindung wirkt dann also auch als Isolator zwischen den Elektroden.

In einer Ausführungsform weisen die Elektroden und die Leiterbahnen jeweils eine raue Oberfläche auf. Die Elektroden und die Leiterbahnen sind dann so beabstandet, dass die Elektroden und die Leiterbahnen in direktem Kontakt, insbesondere elektrischem Kontakt, stehen. Insbesondere stehen die Elektroden mit korrespondierenden Kontakten der Leiterbahnen auf dem Träger in Kontakt.

In dieser Ausführungsform kann die Kontaktseite des piezoelektrischen Elements einschließlich der Elektroden und die der Kontaktseite gegenüberliegende Trägerinnenseite einschließlich der Kontakte der Leiterbahnen mittels einer dazwischen angeordneten Klebeverbindung mechanisch verbunden sein.

Durch die vorgegebene Oberflächenrauheit der Elektroden und der Kontakte der Leiterbahnen stehen die Elektroden und die Kontakte bei einer ausreichend dünn ausgebildeten Klebeverbindung an Kontaktstellen, an denen ausgeprägte Erhebungen auf den Oberflächen der Elektroden bzw. der Kontakte vorhanden sind, an einzelnen Stellen in direktem Kontakt miteinander.

Das heißt es bilden sich Kontaktstellen aus, an denen kein Träger-Klebemittel zwischen einer Erhebung auf der Oberfläche einer der Elektroden und eines korrespondierenden Kontaktes oder einer Erhebung auf der Oberfläche eines Kontaktes und einer korrespondierenden Elektrode vorhanden ist.

Durch eine ausreichende Oberflächenrauheit der Elektroden bzw. der Kontakte der Leiterbahnen und einen entsprechend geeignet gewählten Abstand zwischen Elektroden und Leiterbahnen wird somit eine ausreichende elektrische Kontaktierung der Elektroden und der Leiterbahnen sichergestellt.

In anderen Worten, die elektrische Anbindung zwischen dem piezoelektrischen Element und den Leiterbahnen des Behältnisses erfolgt durch direkten vielfachen Punktkontakt. Durch die natürlich vorhandenen Rauigkeiten der gegenüberliegenden Flächen, der Oberflächen der beiden Elektroden einerseits und der Kontakte des Trägers andererseits, entstehen lokal Stellen, an denen sich Elektroden und Leiterbahnen direkt berühren. Diese Berührungen erlauben eine gute elektrische Leitung zwischen Elektroden und Leiterbahnen.

Im Falle von Oberflächen deren natürliche Rauigkeit nicht ausreichend groß ist, kann die natürliche Rauigkeit künstlich erhöht werden. Beispielsweise kann die natürliche Rauigkeit durch den Einsatz geeigneter technischer Verfahren erhöht werden, insbesondere kann die natürliche Rauigkeit mittels eines Laserabtragungsprozesses erhöht werden.

Das Träger-Klebemittel selbst ist hier nicht an der elektrischen Kontaktierung beteiligt.

Gleichzeitig vergrößert sich bei einer höheren Oberflächenrauheit die zur Verfügung stehende Kontaktfläche zwischen dem piezoelektrischen Element und dem Träger, sodass die Festigkeit und Beständigkeit der mechanischen Verbindung, insbesondere der Klebeverbindung, und der elektrischen Verbindung des Elements und dem Behältnis verbessert werden können.

In einer Ausführungsform sind die Elektroden und die Kontakte der Leiterbahnen jeweils gegenüber ihrer Umgebung exponiert. D.h., dass zum einen die gesamten Elektroden oder zumindest Abschnitte der Elektroden auf der Kontaktseite des piezoelektrischen Elements hervorstehen. Dieser Effekt kann alleine durch das Auftragen der Elektroden auf der Kontaktseite erreicht werden. Zur Verstärkung des Effekts können die Elektroden zusätzlich verstärkt werden.

Zum anderen stehen die gesamten Kontakte der Leiterbahnen oder Abschnitte der Kontakte auf der Trägerinnenseite hervor. Dieser Effekt kann alleine durch das Auftragen der Kontakte erreicht werden. Zur Verstärkung des Effekts können die Kontakte zusätzlich verstärkt werden.

Die Elektroden und die Kontakte können im Allgemeinen beispielsweise durch Sputtern oder Galvanisierung aufgetragen und/oder verstärkt werden. Die Elektroden und die Kontakte umfassen ein gut elektrisch leitendes Material, bevorzugt ein Metall oder eine Metalllegierung, wie beispielsweise Kupfer, Silber, Nickel oder Chrom, oder einer elektrisch leitenden Kunststoff.

Da die Kontakte und die Elektroden gegenüber ihrer jeweiligen Umgebung exponiert sind, können sie in direktem Kontakt zueinander stehen, während zwischen der übrigen Kontaktseite der piezoelektrischen Schicht und der übrigen Trägerinnenseite eine nichtleitende Klebeverbindung zur mechanischen Verbindung ausgebildet ist.

Durch die zuletzt beschriebene Ausführungsform wird somit eine ausreichende elektrische Kontaktierung der Elektroden und der Kontakte sichergestellt.

In einer weiteren Ausführungsform sind die Elektroden und die Leiterbahnen kapazitiv gekoppelt.

In dieser Ausführungsform stehen die Elektroden und die Kontakte der Leiterbahnen nicht in direktem Kontakt zueinander. Die Kontakte können beispielsweise so im Träger strukturiert sein, dass sie nicht an einer Oberfläche des Trägers freiliegen.

Alternativ oder ergänzend kann zwischen den Elektroden und den Leiterbahnen eine elektrische Isolationsschicht zusätzlich angeordnet sein. Die zusätzliche Isolationsschicht kann aus einem nichtleitenden Material, insbesondere einem organischen Nichtleiter bestehen. Zum Beispiel kann der organische Nichtleiter in Form eines Lackes aufgebracht sein. Besonders bevorzugt kann die Isolationsschicht durch das nichtleitende Träger-Klebemittel selbst ausgebildet werden.

Die beschriebene Ausführungsform hat den Vorteil, dass die Elektroden und die Kontakte einen Kondensator bilden, der ein zusätzliches Kondensatorbauteil in der Elektronik ersetzen kann. Somit können der Aufbau des Ultraschallwandlers, insbesondere der Elektronik, und der Fertigungsprozess vereinfacht werden.

In einer Ausführungsform ist das Träger-Klebemittel anisotrop elektrisch leitend. Das Träger-Klebemittel ist in einer Richtung senkrecht zur Kontaktseite des piezoelektrischen Elements und der Trägerinnenseite elektrisch leitend. Das Träger-Klebemittel fungiert also als elektrischer Leiter zwischen den Elektroden und den zugehörigen Kontakten.

Gleichzeitig wirkt das Träger-Klebemittel als elektrischer Isolator in jeder Richtung parallel zur Kontaktseite des piezoelektrischen Elements. Das Träger-Klebemittel wirkt also ähnlich wie ein nichtleitendes Träger-Klebemittel als Isolator zwischen verschiedenen Elektroden, insbesondere zwischen im Betriebszustand unterschiedlich gepolten Elektroden und/oder unterschiedlich gepolten Kontakten.

Ein solches anisotropes, elektrisch leitendes Träger-Klebemittel stellt eine stabile elektrische Kontaktierung zwischen den Elektroden und den Kontakten der Leiterbahnen sicher und verhindert zugleich unerwünschte elektrische Kontaktierungen oder Kurzschlüsse.

In zumindest einer Ausführungsform sind die Kontakte der Leiterbahnen auf der Trägerinnenseite aufgebracht. Die Trägerinnenseite ist der Kontaktseite des piezoelektrischen Elements zugewandt. Dies ermöglicht eine direkte elektrische Kontaktierung der Kontakte und der Elektroden auf der Kontaktseite des piezoelektrischen Elements. Hierdurch kann der Aufbau des Ultraschallwandlers signifikant vereinfacht werden.

In einer Ausführungsform sind die Kontakte der Leiterbahnen im Träger strukturiert, sodass sie nicht an einer Oberfläche freiliegen. Dies ermöglicht beispielsweise die oben beschriebene Ausbildung eines Kondensators zwischen den Kontakten und den Elektroden.

Das Behältnis weist weiterhin wie zuvor beschrieben Leiterbahnen auf, welche die Elektroden des piezoelektrischen Elements und die Elektronik elektrisch verbinden. Die Elektronik weist Anschlussstellen auf, an denen die elektrische Kontaktierung zwischen der Elektronik und den Leiterbahnen erfolgt. Bevorzugt weist die Elektronik zwei Anschlussstellen auf, die jeweils zur elektrischen Kontaktierung einer Leiterbahn dienen.

Durch die Ausbildung der Leiterbahnen kann auf eine elektrische Verbindung durch Drähte verzichtet werden.

In einer Ausführungsform sind die Leiterbahnen an der inneren Oberfläche des Behältnisses angeordnet. Die Leiterbahnen sind beispielsweise in Form von Metallbahnen auf der inneren Oberfläche des Behältnisses aufgebracht. Hierfür bieten sich gut elektrisch leitende Materialien wie Kupfer, Silber, Nickel oder Chrom an. Die Leiterbahnen werden beispielsweise durch Sputtern aufgebracht.

Erfindungsgemäß ist das Behältnis aus einem elektrisch leitenden Material und es wird auf der Oberfläche des Behältnisses zwischen den Leiterbahnen und dem Behältnis eine Isolationsschicht ausgebildet.

Die Leiterbahnen reichen von den Kontakten des Trägers bis zu dem Abschnitt der Wand des Behältnisses, an dem der Deckel mit der Elektronik angebracht ist. Die Elektronik ist mit den Leiterbahnen in elektrischem Kontakt.

In einer Ausführungsform sind die Leiterbahnen im Inneren des Behältnisses integriert. Die Leiterbahnen können in der Wand des Behältnisses strukturiert sein.

Das Behältnis ist erfindungsgemäß selbst elektrisch leitend.

Erfindungsgemäß wird das Behältnis als eine erste Leiterbahn genutzt. Hierzu ist die Isolationsschicht an einer ersten Kontaktstelle, der Stelle des Kontaktes zur ersten Elektrode, und einer zweiten Kontaktstelle, der Stelle des Kontaktes zu einer Anschlussstelle der Elektronik unterbrochen.

Eine zweite Leiterbahn, die die zweite Elektrode mit der Elektronik verbindet, ist dann auf der Isolationsschicht auf der Innenseite des Behältnisses aufgetragen.

Ist das Behältnis selbst nicht elektrisch leitend, können elektrisch leitende Strukturen als innere Leiterbahnen im Behältnis ausgebildet werden. Zur direkten elektrischen Kontaktierung liegen diese inneren Leiterbahnen an der ersten Kontaktstelle und der zweiten Kontaktstelle frei bzw. reichen dort bis zur inneren Oberfläche des Behältnisses.

In einer Ausführungsform sind die Leiterbahnen und die Elektronik mittels eines elektrisch leitfähigen Deckel-Klebemittels elektrisch verbunden.

Zumindest an der zweiten Kontaktstelle der Leiterbahnen, die gegenüber einer Anschlussstelle der Elektronik ausgebildet ist, wird hierfür das Deckel-Klebemittel aufgetragen, mit dessen Hilfe die Elektronik elektrisch kontaktiert wird.

Das Träger-Klebemittel und das Deckel-Klebemittel sind bevorzugt zwei verschiedene Klebemittel, mit jeweils auf ihre Anwendung bezogenen, optimierten Eigenschaften.

In zumindest einer Ausführungsform ist der Deckel mittels des elektrisch leitfähigen Deckel-Klebemittels auch mechanisch am Behältnis befestigt. Das Deckel-Klebemittel dient also zur mechanischen Befestigung und zur elektrischen Kontaktierung des Deckels.

In einer weiteren Ausführungsform ist der Deckel mittels eines elastischen, nichtleitenden Klebemittels mechanisch am Behältnis befestigt. Das Deckel-Klebemittel dient dann ausschließlich der elektrischen Kontaktierung des Deckels.

Weiterhin wird ein, nicht-erfindungsgemäßer, Ultraschallwandler beschrieben, der ein Behältnis mit einer Einbauöffnung, die mit einem Deckel mit integrierter Elektronik verschließbar ist, aufweist. Der Deckel ist mittels eines elektrisch leitfähigen Deckel-Klebemittels am Behältnis festlegbar und die Elektronik ist mittels des elektrisch leitfähigen Deckel-Klebemittels mit Leiterbahnen des Behältnisses elektrisch kontaktierbar.

Im Übrigen kann der beschriebene Ultraschallwandler alle Merkmale der zuvor beschriebenen Ultraschallwandler aufweisen.

Weiterhin wird ein Verfahren zur Herstellung des erfindungsgemäßen Ultraschallwandlers beschrieben. Das Verfahren umfasst mehrere Schritte.

In einem Schritt a wird ein mit einem Deckel verschließbares Behältnis mit einer Einbauöffnung bereitgestellt. In dem Deckel ist eine Elektronik integriert. Das Behältnis umfasst weiterhin einen als Träger ausgebildeten Boden und Leiterbahnen. Alternativ oder ergänzend kann die Elektronik ganz oder teilweise im Behältnis vorgesehen sein.

In einem Schritt b wird ein piezoelektrisches Element im Behältnis auf dem Träger befestigt. Das piezoelektrische Element wird so befestigt, dass auf dem piezoelektrischen Element angeordnete Elektroden über die Leiterbahnen mit Anschlussstellen der Elektronik elektrisch verbunden werden.

Der Schritt b des Verfahrens kann weiterhin die folgenden Teilschritte umfassen:
In einem Teilschritt wird das piezoelektrische Element so befestigt, dass die Elektroden mit den Leiterbahnen elektrisch gekoppelt werden.

In einem weiteren Teilschritt wird die Einbauöffnung mit dem Deckel verschlossen. Hierbei werden die Anschlussstellen der Elektronik so mit den Leiterbahnen elektrisch gekoppelt, dass die Elektronik drahtlos mit den Elektroden elektrisch verbunden wird.

In einer alternativen Ausführungsform, in der die Elektronik bereits ganz im Behältnis vorgesehen ist, sind die Elektroden und die Elektronik bereits vor dem Schließen des Deckels drahtlos elektrisch verbunden.

In einer Ausführungsform kann das Verfahren weiterhin einen Schritt zum Einführen eines Dämpfungselements zwischen dem piezoelektrischen Element und dem Deckel umfassen. Das Dämpfungselement füllt das Behältnis aus.

Der Ultraschallwandler weist weiterhin alle Merkmale des zuvor beschriebenen erfindungsgemäßen Ultraschallwandlers auf.

In einer Ausführungsform des Verfahrens wird in einem Schritt ein Behältnis bereitgestellt. Das Behältnis weist eine Einbauöffnung, einen Boden, der als Träger fungiert, und eine Wand auf. Auf einer Trägerinnenseite sind Kontakte von Leiterbahnen vorhanden. Die Trägerinnenseite ist hierbei die Seite, die in das Innere des Behältnisses gerichtet ist. Im Behältnis kann ergänzend noch eine Elektronik ganz oder teilweise vorhanden sein.

In einem weiteren Schritt wird ein Träger-Klebemittel auf der Trägerinnenseite aufgetragen.

Das Träger-Klebemittel umfasst bevorzugt einen thermisch härtenden Klebstoff, beispielsweise einen thermisch härtenden Epoxyklebstoff.

In einem weiteren Schritt wird eine Kontaktseite eines piezoelektrischen Elements, auf der zwei Elektroden ausgeprägt sind, auf das Träger-Klebemittel aufgebracht. In einer alternativen Ausführung wird das Träger-Klebemittel auf der Kontaktseite des piezoelektrischen Elements aufgebracht.

In einem weiteren Schritt wird das piezoelektrische Element auf der Trägerinnenseite angepresst, sodass die zwei Elektroden in direktem Kontakt zu den Kontakten des Trägers stehen. Anschließend wird das Träger-Klebemittel ausgehärtet.

Der direkte Kontakt kann beispielsweise durch eine ausreichend hohe Oberflächenrauheit der Kontakte und der Elektroden erreicht werden. Das Träger-Klebemittel wird beim Anpressen teilweise verdrängt, sodass Erhebungen auf den Oberflächen der Kontakte und der Elektroden in direktem Kontakt miteinander stehen.

Eine hohe Oberflächenrauheit resultiert weiterhin in einer vorteilhaften größeren Oberfläche der Elektroden und der Kontakte.

Der direkte Kontakt kann weiterhin durch im Vergleich zu ihrer Umgebung erhöhte Abschnitte der Elektroden und der Kontakte erreicht werden. Beim Anpressen des Träger-Klebemittels wird dieses verdrängt, sodass die erhöhten Flächen in direktem Kontakt miteinander stehen, während zwischen nicht erhöhten Flächen eine Klebeverbindung ausgebildet wird. Beim Anpressen wird in einem Ausführungsbeispiel des Verfahrens eine Kraft von mindestens 0,3 N aufgewendet. Bevorzugt wird eine Kraft von mindestens 0,3 N und maximal 3 N aufgewendet.

Beim Härten kann sich das Träger-Klebemittel zusammenziehen, sodass der Kontakt zwischen den zwei Elektroden und den korrespondierenden Kontakten intensiviert wird.

Das Aushärten des Träger-Klebemittels kann beispielsweise thermisch oder UV-induziert erfolgen.

In einem weiteren Schritt kann vor dem Aufbringen des piezoelektrischen Elements eine elektrische Isolationsschicht auf die Trägerinnenseite oder auf die Kontaktseite des piezoelektrischen Elements aufgebracht werden. Die Isolationsschicht bedeckt zumindest die Kontakte und/oder die Elektroden, sodass diese nichtmehr in elektrischem Kontakt stehen.

Das Aufbringen der Isolationsschicht, die ein nichtleitendes Material umfasst, kann alternativ oder ergänzend zum Aufbringen des Träger-Klebemittels erfolgen. Die Isolationsschicht kann auch das Träger-Klebemittel selbst umfassen. Es kann hierdurch eine Kapazität des nunmehr rein kapazitiven, d.h. nicht ohmschen, Kontakts zwischen den Elektroden und den Leiterbahnen eingestellt werden.

Im Folgenden werden Ausführungsbeispiele der Erfindung anhand von Figuren erläutert. Die Erfindung ist nicht auf die Ausführungsbeispiele und deren Merkmale beschränkt.

Die Figuren zeigen:
Figur 1 (nicht erfindungsgemäß): perspektivische Schnittansicht eines Behältnisses gemäß eines ersten Ausführungsbeispiels des Ultraschallwandlers.
Figur 2: perspektivische Draufsicht eines piezoelektrischen Elements gemäß des ersten Ausführungsbeispiels des Ultraschallwandlers.
Figur 3 (nicht erfindungsgemäß): perspektivische Schnittansicht des Behältnisses und des piezoelektrischen Elements des ersten Ausführungsbeispiels des Ultraschallwandlers.
Figur 4 (nicht erfindungsgemäß): schematische Schnittansicht des ersten Ausführungsbeispiels des Ultraschallwandlers im zusammengebauten Zustand.
Figur 5: detaillierte Darstellung eines Kontaktbereichs mit rillenförmigen Ausfräsungen und Erhebungen.
Figur 6 (nicht erfindungsgemäß): Schnittansicht eines piezoelektrischen Elements und eines Trägers eines zweiten Ausführungsbeispiels.
Figur 7: schematische Schnittansicht des vierten Ausführungsbeispiels des Ultraschallwandlers im zusammengebauten Zustand.
Figur 8 (nicht-erfindungsgemäß): schematische Schnittansicht des fünften Ausführungsbeispiels des Ultraschallwandlers im zusammengebauten Zustand.
Figur 9: detaillierte Darstellung eines zusammengefügten Ultraschallwandlers im Querschnitt.
Figur 10 (nicht erfindungsgemäß): detaillierte Explosionsansicht eines zusammengefügten Ultraschallwandlers.

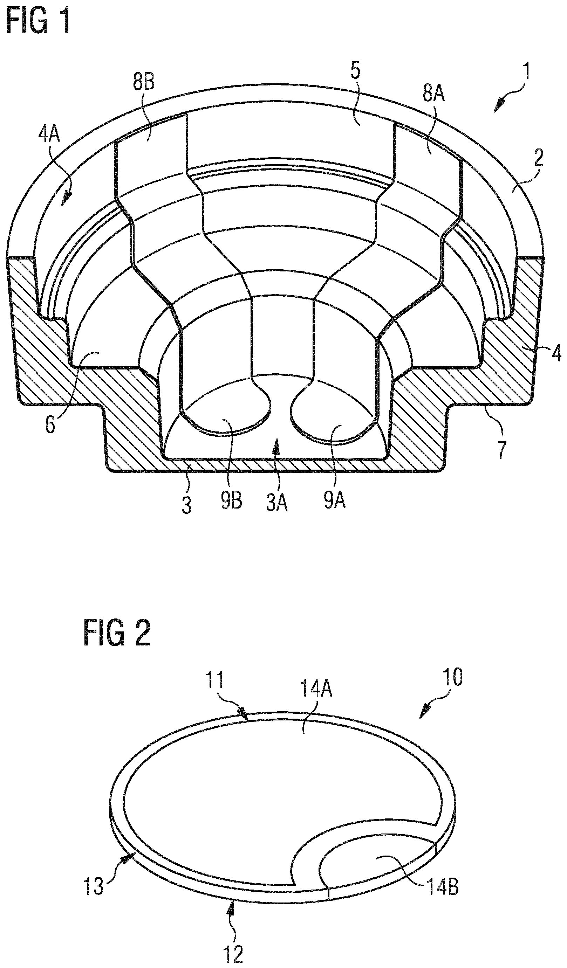

Figur 1 zeigt einen Schnitt durch ein Behältnis 2 eines ersten Ausführungsbeispiels eines Ultraschallwandlers 1.

Das Behältnis 2 ist im vorliegenden Fall einstückig ausgeführt. Das Behältnis 2 umfasst einen Träger 3, der einem Boden 3 des Behältnisses 2 entspricht, eine Wand 4 und eine Öffnung 5 an seiner Oberseite. Der Träger 3 dient als Membran des Ultraschallwandlers 1. Das Behältnis 2 weist eine rotationssymmetrische Form auf, die im Wesentlichen einem Zylinder entspricht. Der Träger 3 ist kreisförmig ausgebildet und bildet die Grundfläche des Zylinders. Die Wand 4 umfasst mehrere Zylinderabschnitte verschiedener Durchmesser, die stufenartig übereinander angeordnet sind. Der Durchmesser des Zylinderabschnitts, der an den Träger 3 angrenzt, ist am geringsten. Der Durchmesser des Zylinderabschnitts, der an die Öffnung 5 angrenzt, ist am größten.

Die Anzahl der Zylinderabschnitte kann je nach Anwendung und technischer Anforderung variieren. Beispielsweise kann die Wand 4 genau einen Zylinderabschnitt umfassen.

In weiteren, nicht dargestellten, Ausführungsbeispielen kann das Behältnis 2 eine beliebige andere Form annehmen. Beispiele für weitere Formen des Behältnisses 2 sind eine konische Form oder eine kubische Form.

Das Behältnis 2 weist im Inneren einen Hohlraum 6 auf. Der Hohlraum 6 wird nach unten durch den Träger 3 und an den Seiten durch die Wand 4 begrenzt. Nach oben ist der Hohlraum 6 geöffnet, da das Behältnis 2 dort die Öffnung 5 aufweist.

Die Oberflächen des Trägers 3 und der Wand 4, die in Richtung des Hohlraums 6 im Inneren des Behältnisses 2 gerichtet sind, werden als Innenseiten bezeichnet. Der Träger 3 weist eine Trägerinnenseite 3A und die Wand 4 weist eine Wandinnenseite 4A auf.

Die nach außen gerichteten Oberflächen des Behältnisses 2 werden entsprechend als Außenseiten bezeichnet.

Im ersten Ausführungsbeispiel umfasst das Behältnis 2 ein elektrisch leitendes Material. Das elektrisch leitende Material ist beispielsweise Aluminium oder eine Aluminiumlegierung. In weiteren Beispielen kann das Behältnis 2 weitere elektrisch leitende oder elektrisch nichtleitende Materialien enthalten.

Im vorliegenden Ausführungsbeispiel ist das Behältnis 2 daher elektrisch leitend. Die Oberflächen des elektrisch leitenden Behältnisses 2 sind mit einer Isolationsschicht 7 beschichtet. Besteht das Behältnis beispielsweise aus Aluminium, kann dieses oxidiert werden, sodass eine elektrisch isolierende Eloxal-Schicht entsteht. Die elektrisch isolierende Eloxal-Schicht weist bevorzugt eine Schichtdicke zwischen 5 und 25 µm auf.

Die Isolationsschicht 7 bedeckt sowohl die Innenseiten wie auch die Außenseiten des Behältnisses 2 vollständig.

Auf der Innenseite des Behältnisses 2 sind zwei getrennte, elektrisch leitende Leiterbahnen 8A und 8B aufgetragen. Die Leiterbahnen erstrecken sich von Kontaktflächen 9A und 9B auf der Trägerinnenseite 3A über die Wandinnenseite 4A bis zur Öffnung 5 des Behältnisses 2.

In einer weiteren, nicht dargestellten Ausführungsform reichen die Leiterbahnen 8A und 8B nicht bis an die Öffnung 5 des Behältnisses 2. In diesem Fall erstrecken sich die Leiterbahnen 8A und 8B nur über einen Teil der Wandinnenseite 4A in Richtung der Öffnung 5 und enden beispielsweise an einer beliebigen Stelle der Wandinnenseite oder einer Stufe zwischen mehreren Zylinderabschnitten.

Die Leiterbahnen 8A und 8B und die Kontaktflächen 9A und 9B umfassen ein elektrisch leitendes Material wie beispielsweise Kupfer, Silber, Nickel oder Chrom. Die Leiterbahnen 8A und 8B bzw. die Kontaktflächen 9A und 9B können per Sputtern oder per Druck, beispielsweise Siebdruck, aufgebracht werden. Alternativ können die Leiterbahnen 8A und 8B bzw. die Kontaktflächen 9A und 9B durch das Aufbringen eines leitfähigen Polymers gebildet werden. Die Kontaktflächen 9A und 9B können zusätzlich mit leitfähigem Material verstärkt sein.

Figur 2 zeigt ein piezoelektrisches Element 10 des ersten Ausführungsbeispiels des Ultraschallwandlers 1.

Das piezoelektrische Element 10 ist als Scheibe, genauer als flacher Zylinder ausgeführt. Der Durchmesser des Zylinders ist deutlich größer als die Höhe des Zylinders. Das piezoelektrische Element 10 weist eine Unterseite 11, eine Oberseite 12 und eine Seitenfläche 13 auf.

In weiteren, nicht dargestellten, Ausführungsbeispielen kann das piezoelektrische Element 10 eine beliebige andere Form, beispielsweise eine andere rotationssymmetrische Form, eine elliptische Form, eine n-eckige Form oder eine kubische Form aufweisen.

Die Unterseite 11 ist die Kontaktseite des piezoelektrischen Elements 10, die im eingebauten Zustand auf der Trägerinnenseite 3A aufgebracht ist, zeigt in Figur 2 aus Gründen der Anschaulichkeit nach oben.

Das piezoelektrische Element umfasst ein piezoelektrisches Material.

Auf der Unterseite 11 ist eine erste Elektrode 14A flächig aufgebracht. Die erste Elektrode 14A ist ausschließlich auf der Unterseite 11 aufgebracht. Die erste Elektrode 14A bedeckt im ersten Ausführungsbeispiel einen Großteil der Unterseite 11.

Auf der Oberseite 12 des piezoelektrischen Elements ist eine zweite Elektrode 14B flächig aufgebracht. Die zweite Elektrode 14B bedeckt im ersten Ausführungsbeispiel einen Großteil der Oberseite 12.

Die zweite Elektrode 14B erstreckt sich weiterhin über die Seitenfläche 13 und die Unterseite 11. Die Elektrode 14B ist dabei zusammenhängend ausgebildet. Die erste Elektrode 14A und die zweite Elektrode 14B sind beabstandet ausgebildet und stehen nicht in Kontakt miteinander. Vielmehr ist auf der Unterseite 11 zwischen den beiden Elektroden 14A und 14B ein Isolationsspalt ausgebildet.

Die Elektroden 14A und 14B umfassen elektrisch leitende Materialien wie beispielsweise Kupfer, Silber, Nickel oder Chrom. Die Elektroden 14A und 14B können beispielsweise per Sputtern oder per Druck, bevorzugt durch Siebdruck, aufgebracht werden.

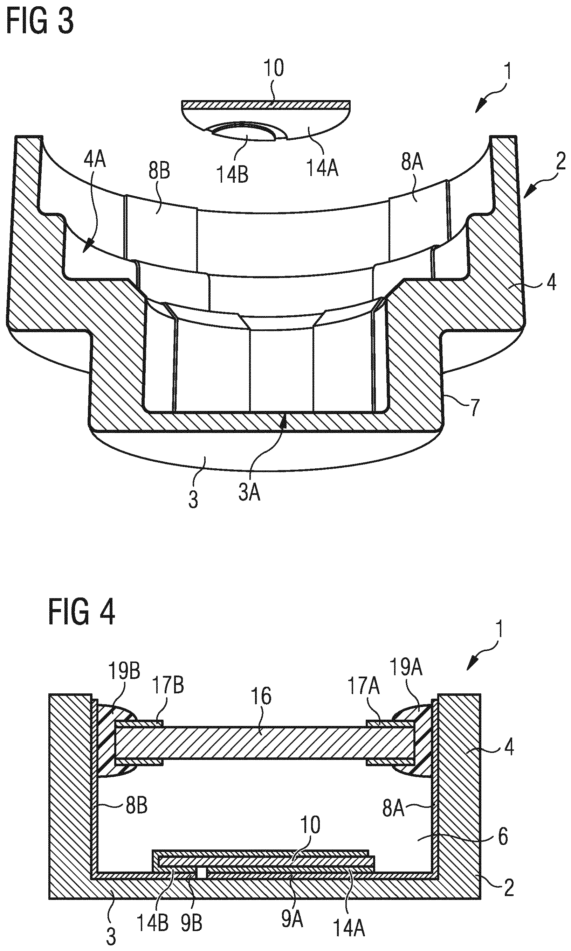

Figur 3 zeigt wie das piezoelektrische Element 10 im Behältnis 2 eingesetzt wird. Die Unterseite 11 des piezoelektrischen Elements 10 wird so auf der Trägerinnenseite 3A aufgebracht, dass die erste Elektrode 14A in direktem Kontakt zur ersten Kontaktfläche 9A und damit zur ersten Leiterbahn 8A steht und dass die zweite Elektrode 14B in direktem Kontakt zur zweiten Kontaktfläche 9B und damit zur zweiten Leiterbahn 8B steht. Es besteht kein Kontakt zwischen der erste Elektrode 14A und der zweiten Kontaktfläche 9B bzw. der zweiten Leiterbahn 8B und es besteht kein Kontakt zwischen der zweite Elektrode 14B und der ersten Kontaktfläche 9A bzw. der ersten Leiterbahn 8A.

Figur 4 zeigt den Ultraschallwandler 1 gemäß des ersten Ausführungsbeispiels im zusammengebauten Zustand.

Das piezoelektrische Element 10 ist wie oben beschrieben im Behältnis 2 angeordnet. Das piezoelektrische Element 10 ist im zusammengebauten Zustand über eine in Figur 4 nicht explizit dargestellte Klebeverbindung am Träger 3 stoffschlüssig befestigt. Die Klebeverbindung ist hierzu flächig zwischen der Unterseite 11 des piezoelektrischen Elements 10 und dem gegenüberliegenden Abschnitt der Trägerinnenseite 3A aufgebracht.

Die Klebeverbindung ist elektrisch nichtleitend. Die Klebeverbindung umfasst im ersten Ausführungsbeispiel einen thermisch härtenden Epoxyklebstoff, der elektrisch nichtleitend ist. In weiteren Ausführungsbeispielen kann die Klebeverbindung andere, elektrisch nichtleitende Klebstoffe umfassen, beispielsweise UV-härtende Klebstoffe.

Die Klebeverbindung kann nichtleitende Partikel oder Füllstoffe aufweisen. Diese Partikel oder Füllstoffe weisen Durchmesser von weniger als 0,3 µm auf, beispielsweise 0,2 µm. Bevorzugt weist die Klebeschicht noch kleinere Partikel auf. Besonders bevorzugt ist die Klebeschicht vollständig frei von Partikeln oder Füllstoffen.

Der elektrische Kontakt zwischen den Elektroden 14A und 14B und den Kontaktflächen 9A und 9B entsteht durch deren Oberflächenrauheit. Bei einer ausreichend hohen Oberflächenrauheit bilden sich einzelne direkte Kontakte zwischen Erhebungen auf der Oberfläche der Elektroden 14A und 14B und Erhebungen auf der Oberfläche der Kontaktflächen 9A und 9B aus, die eine elektrische Kontaktierung sicherstellen. An den Stellen der elektrischen Kontaktierung befindet sich keine Klebeverbindung zwischen den Elektroden 14A und 14B und den Kontaktflächen 9A und 9B.

Eine solche ausreichende Oberflächenrauheit wird beispielsweise bei einer mittleren Rauheit Ra von 0,53 µm, und einer Rautiefe Rz von 3,4 µm der besagten Oberflächen erreicht.

Da der Klebstoff elektrisch nichtleitend ist, wirkt die Klebeverbindung als elektrischer Isolator, insbesondere als Isolator zwischen der ersten Elektrode 14A und der zweiten Elektrode 14B bzw. der ersten Kontaktfläche 9A und der zweiten Kontaktfläche 9B.

Weiterhin schützt die Klebeverbindung die Elektroden und die Kontaktflächen vor Umwelteinflüssen, beispielsweise vor Oxidierung, sodass die Lebensdauer des Ultraschallwandler 1 erhöht wird.

Die Öffnung 5 des Behältnisses 2 ist mit einem Deckel 16 verschlossen. Im Deckel 16 ist Elektronik 17 integriert, die dazu ausgestaltet ist, das piezoelektrische Element 10 zu steuern und auszulesen.

Der Deckel 16 ist im vorliegenden Beispiel durch eine ringförmige, elastische Klebeverbindung 18 mechanisch an der Wand 4 befestigt. Die ringförmige, elastische Klebeverbindung 18 ist nicht elektrisch leitend. Die ringförmige, elastische Klebeverbindung 18 dichtet das Behältnis 2 zwischen der Wand 4 und dem Deckel 5 ab, sodass der Hohlraum 6 vollständig eingeschlossen ist.

Die ringförmige, elastische Klebeverbindung 18 umfasst beispielsweise einen nicht elektrisch leitenden Silikonklebstoff.

Zusätzlich sind zwei elektrisch leitende, elastische Klebeverbindungen 19 zwischen der Elektronik 17 und der Wand 4 aufgebracht, die die Anschlussstellen der Elektronik 17A und 17B und die Leiterbahnen 8A und 8B elektrisch verbinden. Eine erste elektrisch leitende, elastische Klebeverbindung 19A verbindet eine erste Anschlussstelle 17A und die Leiterbahn 8A elektrisch. Eine zweite elektrisch leitende, elastische Klebeverbindung 19B verbindet eine zweite Anschlussstelle 17B und die Leiterbahn 8B elektrisch.

Die elektrisch leitenden, elastischen Klebeverbindungen 19A und 19B umfassen beispielsweise einen leitfähigen Silikonklebstoff. Die elektrisch leitenden, elastischen Klebeverbindungen 19A und 19B weisen beispielsweise einen spezifischen Widerstand zwischen 1×10⁻³ und 3×10⁻² Ohm·cm auf.

Durch die Verwendung eines elastischen Klebstoffes für die Klebeverbindungen 18 bzw. 19 wird sichergestellt, dass einerseits, in Bezug auf die Klebeverbindungen 19A und 19B, eine zuverlässige elektrische Verbindung hergestellt wird und dass andererseits Schwingungen des Behältnisses 2 nicht oder nur abgeschwächt auf die Leiterplatte übertragen werden, was **z.B.** zu ungewollter Schallabstrahlung in Rückwärtsrichtung führen könnte.

Im vorliegenden Ausführungsbeispiel ist der Hohlraum 6 hohl. Eine solche Ausführung vereinfacht den Aufbau des Ultraschallwandlers 1. In weiteren Ausführungsbeispielen, die hier nicht dargestellt sind, kann der Hohlraum 6 mit einem Dämmmaterial gefüllt sein. Da der Hohlraum 6 keine weiteren, störenden Einbauten wie beispielsweise Drähte aufweist, kann das Dämmmaterial bereits im Voraus geformt und ausgehärtet werden. Das vorgeformte Dämmmaterial kann dann einfach in den Hohlraum eingesetzt werden.

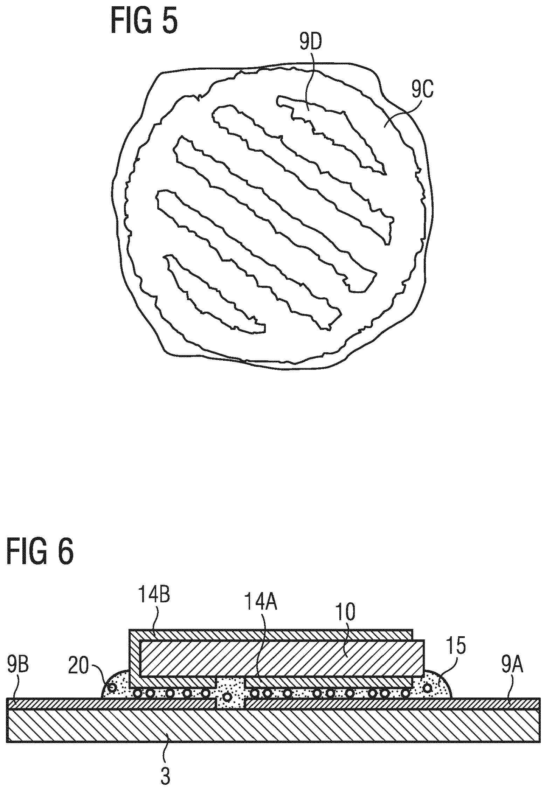

In einer alternativen Ausführungsform des ersten Ausführungsbeispiels werden gezielt Bereiche der Kontaktflächen 9A/9B oder der Elektroden 14A/14B aufgeraut. Das Aufrauen kann mittels Laserbestrahlung vorgenommen werden. So können gezielt Kontaktbereiche in Form von Erhebungen auf der Oberfläche der Elektroden 14A und 14B und Erhebungen auf der Oberfläche der Kontaktflächen 9A und 9B gebildet werden. Die Kontaktbereiche können ein vorgegebenes Muster ausbilden. Zum Beispiel können wie in Figur 5 dargestellt per Laserbestrahlung rillenförmige Ausfräsungen 9C gebildet werden, zwischen denen parallele, langgestreckte Erhebungen 9D ausgebildet sind.

Im Folgenden wird ein zweites Ausführungsbeispiel des Ultraschallwandlers 1 beschrieben, das nicht explizit in den Zeichnungen dargestellt ist. Das zweite Ausführungsbeispiel des Ultraschallwandlers 1 gleicht im Wesentlichen der ersten Ausführungsform des ersten Ausführungsbeispiels des Ultraschallwandlers 1. Gleiche Merkmale der beiden Ausführungsbeispiele werden nicht erneut beschrieben, um Wiederholungen zu vermeiden. Im Folgenden werden Unterschiede der beiden Ausführungsbeispiele beschrieben.

Figur 6 zeigt ein piezoelektrisches Element 10 und einen Träger 3 des zweiten Ausführungsbeispiels. Eine Unterseite 11 des piezoelektrischen Elements 10 ist wie im ersten Ausführungsbeispiel mittels einer Klebeverbindung 15 an der Trägerinnenseite 3A stoffschlüssig festgelegt.

Im Unterschied zum ersten Ausführungsbeispiel ist die Klebeverbindung 15 im zweiten Ausführungsbeispiel anisotrop elektrisch leitend. Die Klebeverbindung 15 ist lediglich in einer Richtung senkrecht zur Unterseite 11 und senkrecht zur Trägerinnenseite 3A elektrisch leitend. In jeder Richtung parallel zur Unterseite 11 bzw. parallel zur Trägerinnenseite 3A ist die Klebeverbindung 15 elektrisch isolierend.

Somit wirkt die Klebeverbindung 15 elektrisch isolierend zwischen der ersten Elektrode 14A und der zweiten Elektrode 14B. Weiterhin wirkt die Klebeverbindung 15 elektrisch isolierend zwischen der ersten Kontaktfläche 9A und der zweiten Kontaktfläche 9B. Zwischen der ersten Elektrode 14A und der ersten Kontaktfläche 9A wirkt die Klebeverbindung 15 hingegen elektrisch leitend. Ebenso wirkt die Klebeverbindung 15 zwischen der zweiten Kontaktfläche 9B und der zweiten Elektrode 14B elektrisch leitend.

Die Klebeverbindung 15 enthält beispielsweise einen anisotropen, elektrisch leitenden Klebstoff, basierend auf einer nichtleitenden Epoxid- oder Acrylat-Matrix, die eine geringe Menge zumindest teilweise leitfähiger oder leitfähig beschichteter Partikel 20 beinhaltet.

Im Folgenden wird ein drittes Ausführungsbeispiel des Ultraschallwandlers 1 beschrieben, das nicht explizit in den Zeichnungen dargestellt ist. Das dritte Ausführungsbeispiel des Ultraschallwandlers 1 gleicht im Wesentlichen dem ersten Ausführungsbeispiel des Ultraschallwandlers 1. Gleiche Merkmale der beiden Ausführungsbeispiele werden nicht erneut beschrieben, um Wiederholungen zu vermeiden. Im Folgenden werden Unterschiede der beiden Ausführungsbeispiele beschrieben.

Im Unterschied zum ersten Ausführungsbeispiel ragen im dritten Ausführungsbeispiel die Elektroden 14A und 14B merklich aus der Unterseite 11 hervor. Ebenso ragen die Kontaktfläche 9A und 9B merklich aus der Trägerinnenseite 3A hervor.

Um dies zu erreichen werden die Elektroden 14A und 14B sowie die Kontaktflächen 9A und 9B während des Fertigungsprozesses verstärkt. Beispielsweise werden die Elektroden oder die Kontaktflächen durch Sputtern von Chrom, Nickel, Silber oder Kupfer verstärkt. Alternativ können die Elektroden und die Kontaktflächen beispielsweise durch Galvanisierung oder Elektroplating verstärkt werden.

Die Klebeverbindung 15 ist im dritten Ausführungsbeispiel ausschließlich um die nicht hervorragenden Oberflächen der Unterseite 11 und der Trägerinnenseite 3A ausgeprägt. Zwischen den hervorragenden Oberflächen der Elektroden 14A, 14B und der Kontaktflächen 9A, 9B ist hingegen keine Klebeverbindung ausgebildet. Der Grund hierfür ist, dass der Klebstoff beim Zusammenpressen des piezoelektrischen Elements 10 und des Trägers 3 verdrängt wird.

Im Folgenden wird ein viertes Ausführungsbeispiel des Ultraschallwandlers 1 beschrieben. Das vierte Ausführungsbeispiel des Ultraschallwandlers 1 gleicht im Wesentlichen dem ersten Ausführungsbeispiel des Ultraschallwandlers 1. Gleiche Merkmale der beiden Ausführungsbeispiele werden nicht erneut beschrieben, um Wiederholungen zu vermeiden. Im Folgenden werden Unterschiede der beiden Ausführungsbeispiele beschrieben.

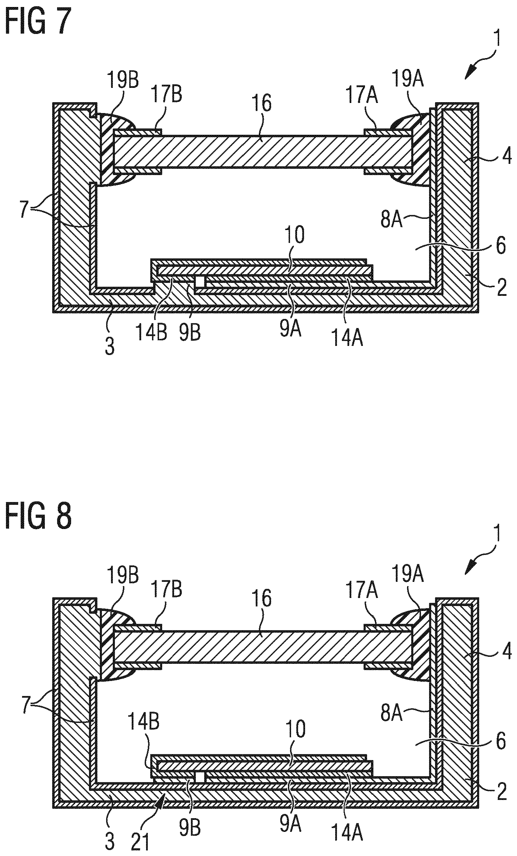

Im vierten Ausführungsbeispiel, das ein Ausführungsbeispiel gemäß der Erfindung ist, ist die erste Kontaktstelle 9A über die erste Leiterbahn 8A mit der Elektronik 17 elektrisch verbunden. Anstelle der zweiten Leiterbahn fungiert das Behältnis 2, welches aus elektrisch leitendem Aluminium besteht, selbst als elektrischer Leiter zwischen der zweiten Kontaktstelle 9B und der Elektronik 17, wie in Figur 7 dargestellt.

Hierfür ist die elektrisch isolierende Eloxal-Schicht 2A, an einer ersten Durchbruchstelle an der zweiten Kontaktstelle 9B und an einer zweiten Durchbruchstelle in der Wand 4, die der zweiten Anschlussstelle 17B des Deckels 16 gegenüberliegt, unterbrochen. Das elektrisch leitende Behältnis 2 kann daher an diesen Stellen elektrisch kontaktiert werden. Der Träger 3 und die Wand 4 bilden in dieser Ausführungsform ein zusammenhängendes und elektrisch leitendes Behältnis 2.

An der ersten Durchbruchstelle ist die zweite Kontaktstelle 9B beispielsweise mittels einer elektrisch leitenden Metallschicht aus Chrom, Kupfer, Silber oder Nickel ausgebildet. Die Metallschicht kann beispielsweise durch Sputtern, Galvanisierung, Inkjet-Druck oder Siebdruck aufgebracht sein. Die zweite Kontaktstelle 9B verbindet das elektrisch leitende Behältnis 2 und die zweite Elektrode 14B elektrisch miteinander.

An der zweiten Durchbruchstelle in der Wand 4 ist eine weitere elektrisch leitende Schicht, beispielsweise eine Metallschicht oder eine leitfähige Klebeschicht aufgebracht, die das elektrisch leitende Behältnis 2 und die zweite Anschlussstelle 17B der Elektronik 17 elektrisch verbindet.

In alternativen Ausführungsformen ist die zweite Durchbruchstelle an einer beliebigen Stelle in der Wand 4 ausgebildet. Von der zweiten Durchbruchstelle bis zur zweiten Anschlussstelle 17B ist dann eine zweite Leiterbahn 8B auf der Wandinnenseite 4A aufgetragen.

Ein fünftes, nicht-erfindungsgemäßes, Ausführungsbeispiel gleicht im Wesentlichen dem vierten Ausführungsbeispiel und weist die folgenden Unterschiede auf.

Das elektrisch leitende Behältnis 2, das als zweite Leiterbahn fungiert, ist nicht mit der zweiten Elektrode 14B kontaktiert. Die Eloxal-Schicht 2A an der Trägerinnenseite 3A ist an der Stelle, an der die zweite Kontaktfläche 9B aufgebracht ist, nicht unterbrochen.

In der fünften Ausführungsform bilden das Behältnis 2 und die zweite Kontaktfläche 9B einen elektrischen Kondensator 21. Über den Kondensator 21 kann der anliegende Wechselstromkreis kapazitiv geschlossen werden (AC-Kondensator), wie in Figur 8 dargestellt.

Somit kann ein separater AC-Kondensator in der Elektronik 17 eingespart werden und der apparative Aufbau des Ultraschallwandler 1 vereinfacht sich. Weiterhin ermöglicht diese Ausführungsform die elektrische Kontaktierung des Behältnisses 2 mit Erde.

In einer weiteren Ausführung kann auf die zweite Kontaktstelle 9B ganz verzichtet werden. Der Kondensator wird dann zwischen dem Behältnis 2 und der zweiten Elektrode 14B ausgebildet.

Im Folgenden wird ein sechstes, nicht-erfindungsgemäßes, Ausführungsbeispiel des Ultraschallwandlers 1 beschrieben, das nicht explizit in den Zeichnungen dargestellt ist. Das sechste Ausführungsbeispiel des Ultraschallwandlers 1 gleicht im Wesentlichen dem ersten Ausführungsbeispiel des Ultraschallwandlers 1. Gleiche Merkmale der beiden Ausführungsbeispiele werden nicht erneut beschrieben, um Wiederholungen zu vermeiden. Im Folgenden werden Unterschiede der beiden Ausführungsbeispiele beschrieben.

Das sechste Ausführungsbeispiel weist im Unterschied zum ersten Ausführungsbeispiel ein Behältnis 2 aus nichtleitendem Material auf. Das nichtleitende Material ist beispielsweise ein LCP-Kunststoff (Liquid Crystal Polymere). Alternativ kann das nichtleitende Material einen anderen geeigneten Werkstoff oder eine Mischung verschiedener Werkstoffe umfassen. Beispiele hierfür sind insbesondere Kunststoffe oder Verbundwerkstoffe, die üblicherweise auch für Leiterplatten eingesetzt werden, zum Beispiel FR-4-Verbundswerkstoff.

Das Behältnis 2 kann entsprechend mit der Elektronik 17 verschaltete Mittel aufweisen, um trotz des nichtleitenden Behältnismaterials eine ausreichende Abschirmung von eingestrahlten elektromagnetischen Störungen (Faraday Shielding) zu gewährleisten. Beispielsweise können in dem Behältnis innere Elektrodenstrukturen oder Metallgeflechte (Kupfernetz) vorhanden sein, die mit der Elektronik 17 passend auf Masse verschaltet sind.

In einem siebten Ausführungsbeispiel, das nicht explizit in den Zeichnungen dargestellt ist, kann die Elektronik 17 ganz oder teilweise im Behältnis 2 angeordnet sein oder dieses bilden. Beispielsweise können Leiterbahnen, passive elektrische Bauelemente, aktive elektrische Bauelemente oder elektrische Schaltungen im Behältnismaterial angeordnet sein.

Ein achtes, nicht-erfindungsgemäßes, Ausführungsbeispiel, das nicht explizit in den Zeichnungen dargestellt ist, gleicht im Wesentlichen dem sechsten Ausführungsbeispiel. Im Unterschied zum sechsten Ausführungsbeispiel ist mindestens eine Leiterbahn im Inneren des Behältnisses 2 strukturiert.

Das Behältnis 2 besteht hier beispielsweise aus LCP, das mit 4 % elektrisch leitfähigen Metallpartikeln dotiert ist. Die elektrisch leitfähigen Metallpartikel können im Inneren des Behältnisses 2 so strukturiert werden, dass sie eine Leiterbahn 8B zwischen der Kontaktstelle 9B und der zugehörigen Anschlussstelle 17B der Elektronik 17 bilden, die nicht an der Oberfläche freiliegt. An der Kontakt- bzw. an der Anschlussstelle ist die Leiterbahn 8A bis zur Trägerinnenseite 3A bzw. bis zur Wandinnenseite 4A strukturiert und liegt dort somit frei. Ein mögliches Verfahren zur Ausbildung der Leiterbahn 8B ist das Verschmelzen der leitfähigen Metallpartikel mithilfe eines laserbasierten Verfahrens.

An der Trägerinnenseite 3A kann dann an der Stelle, wo die Leiterbahn 8B freiliegt, durch chemische Prozesse wie Elektroplating oder Galvanisierung leitfähiges Material aufgetragen werden, das die elektrischen Kontaktfläche 9B bildet. Die strukturierte, elektrisch leitende Oberfläche der Leiterbahn 8B kann hierfür als Seed-Layer dienen. Genauso kann eine elektrische Kontaktfläche an der Stelle der Wandinnenseite 4A gebildet werden, wo die Leiterbahn 8B freiliegt.

Die elektrisch nichtleitende Schicht des Behältnisses 2 über der strukturierten Leiterbahn 8B wird beispielsweise abgetragen und die Metallpartikel freigelegt und miteinander verschmolzen. Weiteres elektrisch leitfähiges Material kann aufgetragen werden.

Im Übrigen kann der Ultraschallwandler 1 des achten Ausführungsbeispiels analog zum vierten Ausführungsbeispiel ausgebildet sein.

Weiterhin ist auch die Ausbildung von AC-Kondensatoren wie im fünften Ausführungsbeispiel möglich, wenn die Leiterbahn 8B, im Inneren des Behältnisses 2, nicht bis zur Trägerinnenseite 3A strukturiert ist, sodass eine nichtleitende Schicht des Behältnisses 2 zwischen der Leiterbahn 8B und der Trägerinnenseite 3A verbleibt.

Im achten Ausführungsbeispiel können im Unterschied zum fünften Ausführungsbeispiel zwei separate Leiterbahnen 8A und 8B im Behältnis 2 strukturiert werden, da das Behältnis 2 selbst nicht leitfähig ist. In diesem Fall sind keine weiteren Leiterbahnen, die auf der Trägerinnenseite 3A oder der Wandinnenseite 4A aufgetragen werden, nötig.

Weiterhin können im vorliegenden Ausführungsbeispiel zwei AC-Kondensatoren, jeweils einer zwischen erster Elektrode 14A und erster Leiterbahn 8A und einer zwischen zweiter Elektrode 14B und zweiter Leiterbahn 8B ausgebildet werden.

Im Folgenden wird ein neuntes, nicht-erfindungsgemäßes, Ausführungsbeispiel des Ultraschallwandlers 1 beschrieben, das nicht explizit in den Zeichnungen dargestellt ist. Das neunte Ausführungsbeispiel des Ultraschallwandlers 1 gleicht im Wesentlichen dem ersten Ausführungsbeispiel des Ultraschallwandlers 1. Gleiche Merkmale der beiden Ausführungsbeispiele werden nicht erneut beschrieben, um Wiederholungen zu vermeiden. Im Folgenden werden Unterschiede der beiden Ausführungsbeispiele beschrieben.

Das neunte Ausführungsbeispiel weist im Unterschied zum ersten Ausführungsbeispiel keine Klebeverbindung 15 zwischen dem piezoelektrischen Element 10 und dem Träger 3 auf. Vielmehr sind die Elektroden 14A bzw. 14B direkt mit den korrespondierenden Kontaktflächen 9A bzw. 9B stoffschlüssig verbunden.

Dies wird beispielsweise erreicht, indem zuerst die Elektroden 14A und 14B und die Kontaktflächen 9A und 9B durch Sputtern aufgebracht werden. In einem zweiten Schritt werden dann das piezoelektrische Element 10 und die Trägerinnenseite 3A so aneinander gepresst, dass die erste Elektrode 14A auf der ersten Kontaktfläche 9A und die zweite Elektrode 14B auf der zweiten Kontaktfläche 9B aufliegt. Der gesamte beschriebene Aufbau wird dann erwärmt, sodass eine elektrische und mechanische stoffschlüssige Verbindung zwischen den Kontaktflächen und den Elektroden entsteht. So kann eine besonders gute Kopplung zwischen dem piezoelektrischen Element 10 und dem Träger 3 erreicht werden. Das piezoelektrische Element 10 ist somit auch am Träger 3 befestigt.

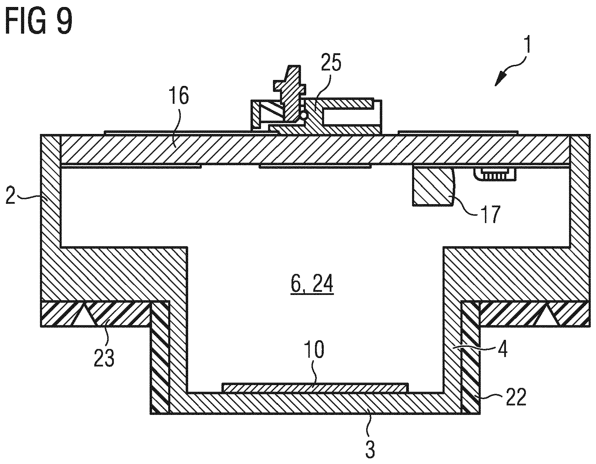

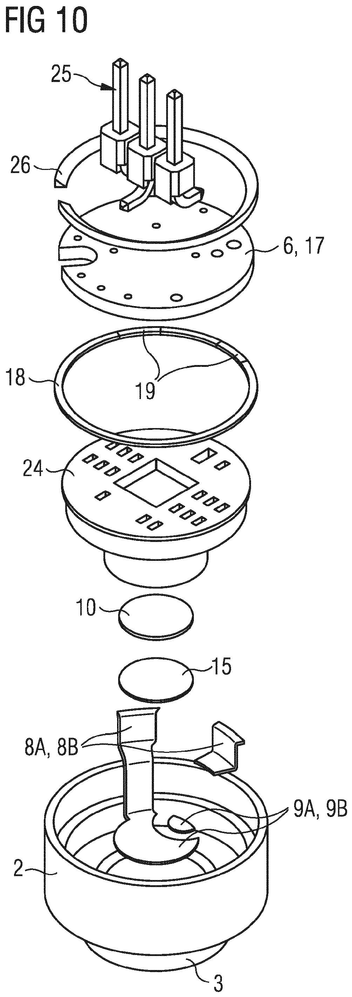

Der Ultraschallwandler 1 gemäß jedem der Ausführungsbeispiele kann weitere Bauteile und Elemente über die zuvor gezeigten Elemente hinaus aufweisen. Ein beispielhafter, detaillierter Aufbau eines solchen Ultraschallwandlers 1 ist in den Figuren 9 und 10 dargestellt.

Das doppelzylinderförmige Behältnis 2 weist einen zylinderförmigen unteren Teil mit kleinerem Durchmesser und einen zylinderförmigen oberen Teil mit größerem Durchmesser auf. Der untere Teil grenzt an den Träger 3, der obere Teil an den Deckel 16. Der untere und der obere Teil sind über eine Verbindungsfläche, parallel zum Träger 3 und zum Deckel 16, miteinander verbunden.

Die Wand 4 des unteren Teils des Behältnisses 2 ist mit einer vibrationsdämpfenden Komponente 22 von außen verkleidet. Die Verbindungsfläche zwischen dem unteren und dem oberen Teil des Behältnisses 2 ist von außen mit adhäsiven Material 23 versehen. Auf den Träger 3 im Inneren des Behältnisses 2 ist das piezoelektrische Element 10 festgelegt. Darüber ist das Dämpfungselement 24, das den Hohlraum 6 des Behältnisses 2 zum Großteil oder insgesamt ausfüllt, angeordnet. Das Dämpfungselement 24 kann bereits vor dem Zusammenbau des Ultraschallwandlers gefertigt und gehärtet werden.

Zwischen dem Träger 3 und dem piezoelektrischen Element 10 können je nach Ausführungsform elektrische Kontaktflächen 9A/9B und ein Klebemittel 15 angeordnet sein. Die Kontaktflächen 9A/B können Teil der Leiterbahnen 8A/8B sein (vgl. Figur 10).

Die Verbindungsfläche zwischen dem oberen und unteren Teil des Behältnisses 2 ist dicker als der Rest des Behältnisses **2.** Die verstärkte Verbindungsfläche ist dafür ausgelegt als Auflageflächen an einer Befestigung, einem Gerüst oder einem Tragwerk in einer Anwendung genutzt zu werden.

Der Träger 3, der auch als Membran genutzt wird, ist dünner als 1 mm. Auf der einen Seite muss der Träger 3 elastisch genug sein, um den Auslenkbewegungen des piezoelektrischen Elements 10 nicht stark zu behindern. Auf der anderen Seite muss der Träger 3 eine gewisse Stabilität aufweisen, damit er bei einer äußeren Krafteinwirkung, wie etwa bei einer Bestrahlung mit Wasser zur Reinigung, keinen Schaden nimmt. Ein vorteilhafter Kompromiss wurde bei einer Stärke vom Träger 3 von weniger als 1 mm und mehr als 0,2 mm gefunden.

Die Wände sind mindestens 1,5-fach so dick wie der Träger 3, sollten aber nach Möglichkeit dicker als das 3-fache der Stärke des Trägers 3 sein. Eine so dicke Wandstärke ist geeignet die Übertragung von Vibrationen des Trägers 3 bzw. der Membran zu der Verbindungsfläche zwischen oberen und unteren Teil des Behältnisses 2 zu mindern. Da die Verbindungsfläche eine Auflagefläche des Ultraschallwandlers 1 zu einer Befestigung sein kann, sollte gerade an diese Verbindungflächen Vibrationen und Auslenkungen vermieden werden. Ansonsten können Vibrationen an eine angrenzende Befestigung, die zur Applikation gehört, übertragen werden. Die übertragenen Vibrationen können wiederum reflektiert werden und daher im Ultraschallwandler 1 als Phantomsignal fälschlicherweise als ein Messsignal erfasst werden. Eine Wandstärke die mindestens das 1,5-fache der Stärke der Membran beträgt, mindert die Übertragung von Vibrationen vom Träger 3 an andere Teile des Behältnisses 2 und beugt so diesem Problem vor.

Der Deckel 16 ist eine Leiterplatte und weist auf einer Seite, die nach außen zeigt, eine digitale I/O Schnittstelle 25 auf.

Über die digitale I/O Schnittstelle 25 wird nicht nur die Kommunikation nach außen realisiert, sondern auch die Elektronik 17 und somit das piezoelektrische Element 10 mit Elektrizität versorgt. Die Elektronik 17 ist auf einer Seite des Deckels 6 angeordnet, die in das Innere des Behältnisses 2 zeigt.

Die Anordnung der digitalen I/O Schnittstelle 25 auf dem Deckel 16 ermöglicht eine kompakte Bauweise des Ultraschallwandlers 1 und eine einfache Kontaktierung, da keine weiteren Anschlüsse zu beachten sind. Im Gegensatz zu analogen Schnittstellen besitzt eine digitale I/O Schnittstelle 25 eine hohe Toleranz bezüglich Störsignalen, die beispielsweise von naheliegenden Elektromotoren stammen können. Beispielsweise kann die Schnittstelle auch mit einem FFC-Konnektor realisiert werden. Dieser stellt über seine acht Kontakte ein Debug-Interface zur Verfügung, welches eine Vielzahl an Auslesemöglichkeiten bietet, die insbesondere für Entwickler und bei aufwendigeren Anwendungen vorteilhaft sein können. Als besonders einfache Alternative kann 2- oder 3-Wire-Interface als Schnittstelle verwendet werden. Diese sind gegenüber den vorher genannten Alternativen Schnittstellen am kostengünstigsten. Auch einfache Stiftleisten, die mit zwei bis acht Stiften versehen sind, sind als Schnittstelle für den Ultraschwallwandler 1 möglich.

Der Deckel 16 ist durch eine ringförmige, elastische Klebeverbindung 18 mechanisch am Behältnis 2 befestigt. Die ringförmige, elastische Klebeverbindung 18 ist nicht elektrisch leitend. Die ringförmige, elastische Klebeverbindung 18 ist an der Seite des Deckels 16, die in das Innere des Behältnisses 2 zeigt, zwischen dem Deckel 16 und dem Behältnis 2 angebracht.

Zusätzlich oder alternativ sind elektrisch leitende, elastische Klebeverbindungen 19 zwischen der Elektronik 17 und dem Behältnis 2 angebracht, die die Anschlussstellen der Elektronik 17 und die Leiterbahnen 8A und 8B elektrisch verbinden. Die elektrisch leitenden, elastischen Klebeverbindungen 19 können Abschnitte der ringförmigen, elastischen Klebeverbindung 18 ersetzen (vgl. Figur 10).

Zusätzlich kann an der Seite des Deckels 16, die nach außen zeigt, eine zweite ringförmige, elastische Klebeverbindung 26 zwischen dem Deckel 16 und dem Behältnis 2 angebracht sein. Die zweite ringförmige, elastische Klebeverbindung 26 dichtet das Behältnis 2 nach außen ab. Die zweite ringförmige, elastische Klebeverbindung 26 kann dieselben Eigenschaften wie die erste ringförmige, elastische Verbindung 18 oder andere Eigenschaften aufweisen.

### Bezugszeichenliste

- 1: Ultraschallwandler
- 2: Behältnis
- 2A: Eloxal-Schicht
- 3: Träger, Boden
- 3A: Trägerinnenseite
- 4: Wand
- 4A: Wandinnenseite
- 5: Öffnung
- 6: Hohlraum
- 7: Isolationsschicht
- 8: Leiterbahn
- 8A: erste Leiterbahn
- 8B: zweite Leiterbahn
- 9: Kontaktfläche
- 9A: erste Kontaktfläche
- 9B: zweite Kontaktfläche
- 9C: Ausfräsung
- 9D: Erhebung
- 10: piezoelektrisches Element
- 11: Unterseite
- 12: Oberseite
- 13: Seitenfläche
- 14: Elektroden
- 14A: erste Elektrode
- 14B: zweite Elektroden
- 15: Klebeverbindung
- 16: Deckel
- 17: Elektronik
- 17A: erste Anschlussstelle
- 17B: zweite Anschlussstelle
- 18: erste ringförmige, elastische Klebeverbindung
- 19: elektrisch leitende, elastische Klebeverbindungen
- 19A: erste elektrisch leitende, elastische Klebeverbindung
- 19B: zweite elektrisch leitende, elastische Klebeverbindung
- 20: leitfähige Partikel
- 21: AC-Kondensator
- 22: vibrationsdämpfende Komponente
- 23: adhäsives Material
- 24: Dämpfungselement
- 25: I/O Schnittstelle
- 26: zweite ringförmige, elastische Klebeverbindung

## Patentansprüche

1. Ein Ultraschallwandler (1) aufweisend einen Deckel (16), ein Behältnis (2) mit einem Boden (3), der als Träger (3) ausgestaltet ist, einer Wand (4) und einer Einbauöffnung (5), die mit dem Deckel (16) verschließbar ist, Elektronik (17), die im Behältnis und/oder im Deckel integriert ist, ein piezoelektrisches Element (10), das eine Kontaktseite (11) aufweist, die auf dem Träger (3) befestigt ist, und Leiterbahnen (8), die Elektroden (14) des piezoelektrischen Elements (10) und Anschlussstellen (17A,17B) der Elektronik (17) elektrisch miteinander verbinden,
wobei die Elektroden (14) eine erste Elektrode (14A) und eine zweite Elektrode (14B) umfassen, wobei die erste Elektrode (14A) flächig auf der Kontaktseite (11) des piezoelektrischen Elements (10) angeordnet ist, und wobei die zweite Elektrode (14B) im Wesentlichen flächig auf einer zur Kontaktseite (11) entgegengesetzten Seite (12) des piezoelektrischen Elements (10) angeordnet ist und wobei weiterhin Teile der zweiten Elektrode (14B) auf einer Seitenfläche (13) und auf der Kontaktseite (11) des piezoelektrischen Elements (10) angeordnet sind,
wobei das Behältnis (2) selbst elektrisch leitend ist und das elektrisch leitende Behältnis (2) auf seinen Oberflächen mit einer Isolationsschicht (7) beschichtet ist,
wobei die Isolationsschicht (7) an einer ersten Kontaktstelle, der Stelle des Kontaktes zu der ersten Elektrode (14A), und einer zweiten Kontaktstelle, der Stelle des Kontaktes zu einer Anschlussstelle der Elektronik (17), unterbrochen ist, so dass das Behältnis als eine erste Leiterbahn genutzt wird,
wobei eine zweite Leiterbahn (8B), die die zweite Elektrode (14B) mit der Elektronik verbindet, auf der Isolationsschicht (7) auf der Innenseite des Behältnisses (2) aufgetragen ist, und die Leiterbahnen (8) und die Elektroden (14) über die Kontaktseite (11) des Elements (10) elektrisch gekoppelt sind.

2. Ein Ultraschallwandler (1) aufweisend einen Deckel (16), ein Behältnis (2) mit einem Boden (3), der als Träger (3) ausgestaltet ist, einer Wand (4) und einer Einbauöffnung (5), die mit dem Deckel (16) verschließbar ist, Elektronik (17), die im Behältnis und/oder im Deckel integriert ist, ein piezoelektrisches Element (10), das eine Kontaktseite (11) aufweist, die auf dem Träger (3) befestigt ist, und Leiterbahnen (8), die Elektroden (14) des piezoelektrischen Elements (10) und Anschlussstellen (17A,17B) der Elektronik (17) elektrisch miteinander verbinden,
wobei die Elektroden (14) eine erste Elektrode (14A) und eine zweite Elektrode (14B) umfassen, wobei die erste Elektrode (14A) flächig auf der Kontaktseite (11) des piezoelektrischen Elements (10) angeordnet ist, und wobei die zweite Elektrode (14B) im Wesentlichen flächig auf einer zur Kontaktseite (11) entgegengesetzten Seite (12) des piezoelektrischen Elements (10) angeordnet ist und wobei weiterhin Teile der zweiten Elektrode (14B) auf einer Seitenfläche (13) und auf der Kontaktseite (11) des piezoelektrischen Elements (10) angeordnet sind,
wobei das Behältnis (2) selbst elektrisch leitend ist und das elektrisch leitende Behältnis (2) auf seinen Oberflächen mit einer Isolationsschicht (7) beschichtet ist,
wobei eine erste Leiterbahn (8A), die die erste Elektrode (14A) mit der Elektronik verbindet, auf der Isolationsschicht (7) auf der Innenseite des Behältnisses (2) aufgetragen ist, wobei die Isolationsschicht (7) an einer ersten Kontaktstelle, der Stelle des Kontaktes zu der zweiten Elektrode (14B) , und einer zweiten Kontaktstelle, der Stelle des Kontaktes zu einer Anschlussstelle der Elektronik (17), unterbrochen ist, so dass das Behältnis als eine zweite Leiterbahn genutzt wird,
und die Leiterbahnen (8) und die Elektroden (14) über die Kontaktseite (11) des Elements (10) elektrisch gekoppelt sind.

3. Ultraschallwandler (1) gemäß einem der Ansprüche 1 oder 2, wobei der Ultraschallwandler dazu ausgestaltet ist, dass die Elektroden (14) im Betriebszustand unterschiedlich polarisiert sind.

4. Ultraschallwandler (1) gemäß einem der Ansprüche 1 bis 3, wobei der Ultraschallwandler dazu ausgestaltet ist, dass zwischen den Elektroden (14) im Betriebszustand eine Spannung angelegt wird.

5. Ultraschallwandler (1) gemäß einem der Ansprüche 1 bis 4, wobei mittels eines elektrisch leitfähigen Deckel-Klebemittels (19) der Deckel (16) am Behältnis (2) festlegbar und die im Deckel integrierte Elektronik (17) mit den Leiterbahnen (8) elektrisch kontaktierbar ist.

6. Ultraschallwandler (1) gemäß Anspruch 5, wobei ein Dämpfungselement in einem Hohlraum in dem Behältnis (2) zwischen dem Träger (3) mit dem piezoelektrischen Element (10) und dem Deckel (16) angeordnet ist.

7. Ultraschallwandler (1) gemäß einem der Ansprüche 1 bis 6, wobei die Elektroden (14) auf dem piezoelektrischen Element (10) und die Anschlussstellen (17A,17B) der Elektronik (17) ausschließlich durch die Leiterbahnen (8) elektrisch verbunden sind.

8. Ultraschallwandler (1) gemäß einem der Ansprüche 1 bis 7, wobei das piezoelektrische Element (10) eine piezoelektrische Scheibe ist.

9. Ultraschallwandler (1) gemäß einem der Ansprüche 1 bis 8, wobei die Kontaktseite (11) des piezoelektrischen Elements (10) mittels eines Träger-Klebemittels (15) an dem Träger (3) befestigt ist, wobei das Träger-Klebemittel (15) elektrisch isolierend ist.

10. Ultraschallwandler (1) gemäß Anspruch 9, wobei die Elektroden (14) und die Leiterbahnen (8) raue Oberflächen aufweisen, die so beabstandet sind, dass die Elektroden (14) und die Leiterbahnen (8) in direktem Kontakt stehen.

11. Ultraschallwandler (1) gemäß Anspruch 9, wobei Abschnitte der Elektroden (14) und der Leiterbahnen (8) gegenüber ihrer Umgebung exponiert sind und in direktem Kontakt miteinander stehen.

12. Ultraschallwandler (1) gemäß einem der Ansprüche 1 bis 8, wobei die Kontaktseite (11) des piezoelektrischen Elements (10) mittels eines Träger-Klebemittels (15) an dem Träger (3) befestigt ist, und wobei das Träger-Klebemittel (15) anisotrop elektrisch leitend ist, sodass die das Träger-Klebemittel (15) als elektrische Kontaktierung zwischen den Elektroden (14) und den Leiterbahnen (8) ausgebildet ist und gleichzeitig verschiedene Elektroden (14) voneinander isoliert sind.

13. Ultraschallwandler (1) gemäß einem der Ansprüche 1 bis 12, wobei das Behältnis (2) rotationssymmetrisch ausgeführt ist.

14. Ultraschallwandler (1) gemäß Anspruch 13, wobei das Behältnis (2) zylinderförmig, konisch oder kegelstumpfförmig, ausgeführt ist.

15. Verfahren zur Herstellung eines Ultraschallwandlers (1) gemäß einem der Ansprüche 1 oder 2, aufweisend die Schritte:
a) Bereitstellen des Deckels (16) mit integrierter Elektronik (17) und des mit dem Deckel (16) verschließbaren Behältnisses (2) mit der Einbauöffnung (5), umfassend den als Träger (3) ausgebildeten Boden (3) und die Leiterbahnen (8),
b) Befestigen des piezoelektrischen Elements (10) im Behältnis (2) auf dem Träger (3), sodass die auf dem piezoelektrischen Element (10) angeordneten Elektroden (14) über die Leiterbahnen (8) mit Anschlussstellen (17A, 17B) der Elektronik (17) elektrisch verbunden werden.

16. Verfahren zur Herstellung eines Ultraschallwandlers (1) gemäß Anspruch 15, wobei Schritt b umfasst:
Befestigen des piezoelektrischen Elements (10), sodass die Elektroden (14) mit den Leiterbahnen (8) elektrisch gekoppelt werden, und Verschließen der Einbauöffnung (5) mit dem Deckel (16), wobei Anschlussstellen (17A, 17B) der Elektronik (17) mit den Leiterbahnen (8) elektrisch gekoppelt werden, sodass die Elektronik (17) drahtlos mit den Elektroden (14) elektrisch verbunden wird.

17. Verfahren zur Herstellung eines Ultraschallwandlers (1) gemäß Anspruch 15 oder 16, weiterhin aufweisend einen Schritt zum Einführen eines das Behältnis (2) ausfüllenden Dämpfungselements (24) zwischen dem piezoelektrischen Element (10) und dem Deckel (16).

## Claims

1. An ultrasonic transducer (1) comprising a cover (16), a housing (2) with a bottom (3) configured as a carrier (3), a wall (4), and an installation opening (5), which can be closed by the cover (16), electronics (17) integrated into the housing and/or the cover, a piezoelectric element (10) having a contact side (11) that is secured to the carrier (3), and
conductor tracks (8) that electrically connect electrodes (14) of the piezoelectric element (10) and connection points (17A, 17B) of the electronics (17) to one another,
wherein the electrodes (14) comprise a first electrode (14A) and a second electrode (14B), wherein the first electrode (14A) is arranged in a planar manner on the contact side (11) of the piezoelectric element (10), and wherein the second electrode (14B) is arranged substantially over the entire surface on a side (12) of the piezoelectric element (10) opposite the contact side (11), and wherein, furthermore, portions of the second electrode (14B) are arranged on a side surface (13) and on the contact side (11) of the piezoelectric element (10),
wherein the housing (2) itself is electrically conductive and the electrically conductive housing (2) is coated on its surfaces with an insulating layer (7),
wherein the insulating layer (7) is interrupted at a first contact point, the point of contact with the first electrode (14A), and a second contact point, the point of contact with a connection point of the electronics (17), so that the housing is used as a first conductor track,
wherein a second conductor track (8B), which connects the second electrode (14B) to the electronics, is applied to the insulating layer (7) on the inner side of the housing (2), and the conductor tracks (8) and the electrodes (14) are electrically coupled via the contact side (11) of the element (10).

2. An ultrasonic transducer (1) comprising a cover (16), a housing (2) with a bottom (3) configured as a carrier (3), a wall (4), and an installation opening (5), which can be closed by the cover (16), electronics (17) integrated into the housing and/or the cover, a piezoelectric element (10) having a contact side (11) secured to the carrier (3), and conductor tracks (8) that electrically connect electrodes (14) of the piezoelectric element (10) and connection points (17A, 17B) of the electronics (17) to one another,
wherein the electrodes (14) comprise a first electrode (14A) and a second electrode (14B), wherein the first electrode (14A) is arranged in a planar manner on the contact side (11) of the piezoelectric element (10), and wherein the second electrode (14B) is arranged substantially over the entire surface on a side (12) of the piezoelectric element (10) opposite the contact side (11), and wherein, furthermore, portions of the second electrode (14B) are arranged on a side surface (13) and on the contact side (11) of the piezoelectric element (10),
wherein the housing (2) itself is electrically conductive and the electrically conductive housing (2) is coated on its surfaces with an insulating layer (7),
wherein a first conductor track (8A), which connects the first electrode (14A) to the electronics, is applied to the insulating layer (7) on the inner side of the housing (2), wherein the insulating layer (7) is interrupted at a first contact point, the point of contact with the second electrode (14B), and a second contact point, the point of contact with a connection point of the electronics (17), so that the housing is used as a second conductor track,
and the conductive tracks (8) and the electrodes (14) are electrically coupled via the contact side (11) of the element (10).

3. An ultrasonic transducer (1) according to any one of claims 1 or 2, wherein the ultrasonic transducer is configured such that the electrodes (14) are differently polarized in the operating state.

4. An ultrasonic transducer (1) according to any one of claims 1 to 3, wherein the ultrasonic transducer is configured such that a voltage is applied between the electrodes (14) in the operating state.

5. An ultrasonic transducer (1) according to any one of claims 1 to 4, wherein the cover (16) can be secured to the housing (2) by means of an electrically conductive cover adhesive (19) and the electronics (17) integrated in the cover can be electrically connected to the conductor tracks (8).

6. An ultrasonic transducer (1) according to claim 5, wherein a damping element is arranged in a cavity within the housing (2) between the carrier (3) with the piezoelectric element (10) and the cover (16).

7. An ultrasonic transducer (1) according to any one of claims 1 to 6, wherein the electrodes (14) on the piezoelectric element (10) and the connection points (17A, 17B) of the electronics (17) are electrically connected exclusively via the conductor tracks (8).

8. An ultrasonic transducer (1) according to any one of claims 1 to 7, wherein the piezoelectric element (10) is a piezoelectric disc.

9. An ultrasonic transducer (1) according to any one of claims 1 to 8, wherein the contact side (11) of the piezoelectric element (10) is attached to the carrier (3) by means of a carrier adhesive (15), wherein the carrier adhesive (15) is electrically insulating.

10. An ultrasonic transducer (1) according to claim 9, wherein the electrodes (14) and the conductor tracks (8) have rough surfaces that are spaced apart such that the electrodes (14) and the conductor tracks (8) are in direct contact.

11. An ultrasonic transducer (1) according to claim 9, wherein portions of the electrodes (14) and the conductor tracks (8) are exposed to their surroundings and are in direct contact with one another.

12. An ultrasonic transducer (1) according to any one of the claims 1 to 8, wherein the contact side (11) of the piezoelectric element (10) is attached to the carrier (3) by means of a carrier adhesive (15), wherein the carrier adhesive (15) is anisotropically electrically conductive, such that the carrier adhesive (15) is configured as an electrical contact between the electrodes (14) and the conductor tracks (8) and, at the same time, different electrodes (14) are insulated from one another.

13. An ultrasonic transducer (1) according to any one of claims 1 to 12, wherein the housing (2) is rotationally symmetrical.

14. An ultrasonic transducer (1) according to claim 13, wherein the housing (2) is cylindrical, conical, or truncated conical in shape.

15. A method for manufacturing an ultrasonic transducer (1) according to any one of claims 1 or 2, comprising the steps of:
a) providing the cover (16) with integrated electronics (17) and the housing (2) with the installation opening (5), which can be closed by the cover (16), comprising the bottom (3) designed as a carrier (3) and the conductor tracks (8),
b) mounting the piezoelectric element (10) in the housing (2) on the carrier (3) such that the electrodes (14) arranged on the piezoelectric element (10) are electrically connected via the conductor tracks (8) to connection points (17A, 17B) of the electronics (17).

16. A method for manufacturing an ultrasonic transducer (1) according to claim 15, wherein step b comprises:
mounting the piezoelectric element (10) such that the electrodes (14) are electrically coupled to the conductor tracks (8), and sealing the installation opening (5) with the cover (16), wherein connection points (17A, 17B) of the electronics (17) are electrically coupled to the conductor tracks (8) so that the electronics (17) are wirelessly electrically connected to the electrodes (14).

17. A method for manufacturing an ultrasonic transducer (1) according to claim 15 or 16, further comprising a step of inserting a damping element (24) filling the housing (2) between the piezoelectric element (10) and the cover (16).

## Revendications

1. Un transducteur ultrasonique (1) comprenant un couvercle (16), un boîtier (2) comportant un fond (3) configuré en support (3), une paroi (4) et d'une ouverture de montage (5), pouvant être fermée par le couvercle (16), un système électronique (17) intégré dans le boîtier et/ou dans le couvercle, un élément piézoélectrique (10) comportant une face de contact (11) fixée sur le support (3), et des pistes conductrices (8) qui relient électriquement entre elles les électrodes (14) de l'élément piézoélectrique (10) et les points de connexion (17A, 17B) du systeme électronique (17) les uns aux autres,
dans lequel les électrodes (14) comprenant une première électrode (14A) et une deuxième électrode (14B), la première électrode (14A) étant disposée à plat sur la face de contact (11) de l'élément piézoélectrique (10), et la deuxième électrode (14B) est disposée essentiellement à plat sur un côté (12) de l'élément piézoélectrique (10) opposé à la face de contact (11), et des parties de la deuxième électrode (14B) étant en outre disposées sur une face latérale (13) et sur la face de contact (11) de l'élément piézoélectrique (10),
dans lequel le boîtier (2) étant lui-même électriquement conducteur et le boîtier (2) électriquement conducteur étant recouvert sur ses surfaces d'une couche isolante (7),
dans lequel la couche isolante (7) étant interrompue au niveau d'un premier point de contact, à savoir le point de contact avec la première électrode (14A), et d'un deuxième point de contact, à savoir le point de contact avec un point de connexion du systeme l'électronique (17), de sorte que le boîtier est utilisé comme une première piste conductrice,
dans lequel une deuxième piste conductrice (8B), qui relie la deuxième électrode (14B) au système électronique, étant appliquée sur la couche isolante (7) à l'intérieur du boîtier (2), et les pistes conductrices (8) et les électrodes (14) étant couplées électriquement par l'intermédiaire de la face de contact (11) de l'élément (10).

2. Un transducteur ultrasonique (1) comprenant un couvercle (16), un boîtier (2) comportant un fond (3) configuré en support (3), une paroi (4) et d'une ouverture de montage (5), pouvant être fermée par le couvercle (16), un système électronique (17) intégré dans le boîtier et/ou dans le couvercle, un élément piézoélectrique (10) comportant une face de contact (11) fixée sur le support (3), et
des pistes conductrices (8) qui relient électriquement entre elles les électrodes (14) de l'élément piézoélectrique (10) et les points de connexion (17A, 17B) du système électronique (17) les uns aux autres,
dans lequel les électrodes (14) comprenant une première électrode (14A) et une deuxième électrode (14B), la première électrode (14A) étant disposée à plat sur la face de contact (11) de l'élément piézoélectrique (10), et la deuxième électrode (14B) est disposée essentiellement à plat sur un côté (12) de l'élément piézoélectrique (10) opposé à la face de contact (11), et des parties de la deuxième électrode (14B) étant en outre disposées sur une face latérale (13) et sur la face de contact (11) de l'élément piézoélectrique (10),
dans lequel le boîtier (2) étant lui-même électriquement conducteur et le boîtier (2) électriquement conducteur étant recouvert sur ses surfaces d'une couche isolante (7),
dans lequel une première piste conductrice (8A), qui relie la première électrode (14A) au système électronique, étant appliquée sur la couche isolante (7) à l'intérieur du boîtier (2),
dans lequel la couche isolante (7) étant interrompue au niveau d'un premier point de contact, à savoir le point de contact avec la deuxième électrode (14B), et d'un deuxième point de contact, à savoir le point de contact avec un point de connexion de l'électronique (17), de sorte que le boîtier est utilisé comme une deuxième piste conductrice,
et les pistes conductrices (8) et les électrodes (14) sont couplées électriquement via la face de contact (11) de l'élément (10).

3. Transducteur ultrasonique (1) selon l'une des revendications 1 ou 2, dans lequel le transducteur ultrasonique est configuré de telle sorte que les électrodes (14) soient polarisées différemment en état de fonctionnement.

4. Transducteur ultrasonique (1) selon l'une des revendications 1 à 3, dans lequel le transducteur ultrasonique est configuré de telle sorte qu'une tension soit appliquée entre les électrodes (14) en état de fonctionnement.

5. Transducteur ultrasonique (1) selon l'une des revendications 1 à 4, dans lequel le couvercle (16) peut être fixé au boîtier (2) au moyen d'un adhésif électriquement conducteur (19) et l'électronique (17) intégrée dans le couvercle peut être mise en contact électrique avec les pistes conductrices (8).

6. Transducteur ultrasonique (1) selon la revendication 5, dans lequel un élément d'amortissement est disposé dans une cavité du boîtier (2) entre le support (3) comportant l'élément piézoélectrique (10) et le couvercle (16).

7. Transducteur ultrasonique (1) selon l'une des revendications 1 à 6, dans lequel les électrodes (14) situées sur l'élément piézoélectrique (10) et les points de connexion (17A, 17B) du système électronique (17) sont reliés électriquement exclusivement par les pistes conductrices (8).

8. Transducteur ultrasonique (1) selon l'une des revendications 1 à 7, dans lequel l'élément piézoélectrique (10) est un disque piézoélectrique.

9. Transducteur ultrasonique (1) selon l'une des revendications 1 à 8, dans lequel la face de contact (11) de l'élément piézoélectrique (10) est fixée au support (3) au moyen d'un adhésif de support (15), l'adhésif de support (15) étant électriquement isolant.

10. Transducteur ultrasonique (1) selon la revendication 9, dans lequel les électrodes (14) et les pistes conductrices (8) présentent des surfaces rugueuses qui sont espacées de telle sorte que les électrodes (14) et les pistes conductrices (8) soient en contact direct.

11. Transducteur ultrasonique (1) selon la revendication 9, dans lequel des parties des électrodes (14) et des pistes conductrices (8) sont exposées à leur environnement et sont en contact direct les unes avec les autres.

12. Transducteur ultrasonique (1) selon l'une quelconque des revendications 1 à 8, dans lequel la face de contact (11) de l'élément piézoélectrique (10) est fixée au support (3) au moyen d'un adhésif de support (15), et dans lequel l'adhésif de support (15) est électriquement conducteur de manière anisotrope, de sorte que l'adhésif de support (15) est configuré comme un contact électrique entre les électrodes (14) et les pistes conductrices (8) tout en isolant les différentes électrodes (14) les unes des autres.

13. Transducteur ultrasonique (1) selon l'une des revendications 1 à 12, dans lequel le boîtier (2) est de forme symétrique en rotation.

14. Transducteur ultrasonique (1) selon la revendication 13, dans lequel le boîtier (2) est de forme cylindrique, conique ou tronconique.

15. Procédé de fabrication d'un transducteur ultrasonique (1) selon l'une des revendications 1 ou 2, comprenant les étapes suivantes :
a) la mise à disposition du couvercle (16) avec électronique (17) intégrée et du boîtier (2) pouvant être fermé par le couvercle (16) et comportant l'ouverture de montage (5), comprenant le fond (3) conçu comme support (3) et les pistes conductrices (8),
b) la fixation de l'élément piézoélectrique (10) dans le boîtier (2) sur le support (3), de telle sorte que les électrodes (14) disposées sur l'élément piézoélectrique (10) soient reliées électriquement, par l'intermédiaire des pistes conductrices (8), à des points de connexion (17A, 17B) de l'électronique (17).

16. Procédé de fabrication d'un transducteur ultrasonique (1) selon la revendication 15, dans lequel l'étape b comprend : la fixation de l'élément piézoélectrique (10) de telle sorte que les électrodes (14) soient couplées électriquement aux pistes conductrices (8), et la fermeture de l'ouverture de montage (5) à l'aide du couvercle (16), les points de connexion (17A, 17B) du système électronique (17) sont couplés électriquement aux pistes conductrices (8), de sorte que le circuit électronique (17) est connecté électriquement sans fil aux électrodes (14).

17. Procédé de fabrication d'un transducteur ultrasonique (1) selon la revendication 15 ou 16, comprenant en outre une étape consistant à insérer un élément d'amortissement (24) remplissant le boîtier (2) entre l'élément piézoélectrique (10) et le couvercle (16).
